# EUROPEAN PATENT SPECIFICATION

(11) **EP 4 367 725 B1**
(45) Date of publication and mention of the grant of the patent: **26.11.2025**
(21) Application number: 22760650.6
(22) Date of filing: 01.07.2022
(51) Int. Cl.: H10F 19/80, H10F 71/10, H10K 71/50

(54) **IMPROVED PHOTOVOLTAIC MODULE AND A LAMINATION METHOD FOR MANUFACTURING OF SUCH A PHOTOVOLTAIC DEVICE**
VERBESSERTES PHOTOVOLTAISCHES MODUL UND LAMINIERUNGSVERFAHREN ZUR HERSTELLUNG EINER SOLCHEN PHOTOVOLTAISCHEN VORRICHTUNG
MODULE PHOTOVOLTAÏQUE AMÉLIORÉ ET PROCÉDÉ DE STRATIFICATION POUR LA FABRICATION D'UN TEL DISPOSITIF PHOTOVOLTAÏQUE

(30) Priority: 06.07.2021 EP 21184017; 06.07.2021 US 202163218561 P
(43) Date of publication of application: 15.05.2024
(73) Proprietor: Epishine AB, 582 13 Linköping (SE)
(72) Inventor: BERGQVIST, Jonas, 585 65 Linghem (SE); ÖSTERBERG, Thomas, 58737 Linköping (SE)
(74) Representative: AWA Sweden AB
(86) International application number: PCT/EP2022/068356
(87) International publication number: WO 2023/280728

(56) References cited:
- WO-A1-2020/038937
- US-A1- 2020 143 995
- US-A1- 2020 203 647

## Description

### TECHNICAL FIELD OF THE INVENTION

The present invention relates to a laminated photovoltaic sheet, a laminated photovoltaic module and a method of producing a laminated photovoltaic sheet.

### BACKGROUND OF THE INVENTION

To mitigate global warming, the energy generation must change from being dominated by fossil fuels to sources with a low climate impact. Photovoltaics, e.g. solar cells, that convert light energy directly to electrical energy, are expected to be a major source of electricity in the future energy system. Commonly used solar cells are commonly produced from silicon oxide that is melted, purified and grown into silicon crystals. This is a highly energy consuming process, why many thin film technologies with less energy demanding manufacturing processes have been developed for manufacturing photovoltaics. Such thin film photovoltaics have low cost and short energy payback time. Further, thin film photovoltaics are lightweight and flexible. In general, a thin film photovoltaic device comprises a photoactive semiconductor sandwiched between two electrodes. A simplest organic photovoltaic is a single layer organic photovoltaic cell made by sandwiching a layer of organic electronic materials between two metallic conductors, typically a layer of indium tin oxide (ITO) with high work function and a layer of low work function metal such as aluminium, magnesium or calcium. The difference of work function between the two conductors sets up an electric field in the organic layer. When the organic layer absorbs light, electrons will be excited to the lowest unoccupied molecular orbital (LUMO) and leave holes in the highest occupied molecular orbital (HOMO), thereby forming excitons. The potential created by the different work functions helps to split the exciton pairs, pulling electrons to the positive electrode (an electrical conductor used to contact a non-metallic part of a circuit) and holes to the negative electrode. A large advantage with this kind of photovoltaics is that they can be printed in a sheet to sheet, roll to roll or roll to sheet process and therefore it is possible to produce large area photovoltaic sheets or photovoltaic modules. Moreover, consumption of material and energy is significantly decreased, enabling a truly low climate impact. These materials are also efficient in converting diffuse light such as scattered sun light or indoor light to electricity. This allows placing organic photovoltaics also on vertical surfaces such as walls.

The problem of aging and degradation of the materials in the thin film photovoltaic modules however is a known issue and affects the functionality of thin film photovoltaics overtime, which leads to decreased efficiency, short circuits and in the worst case malfunctioning of the photovoltaic module. Therefore, there is a need to improve the functionality and durability of thin film photovoltaic modules, especially over time. Related prior art is described in patent publication US 2020/203647 A1.

### SUMMARY OF THE INVENTION

It is accordingly an object of the present invention to improve the current state of the art and to mitigate at least some of the above-mentioned shortcomings. These and other objects are achieved by providing an improved photovoltaic sheet and an improved method for producing such a photovoltaic sheet as defined in the appended claims.

Directions and extensions of the photovoltaic sheet and/or module will be discussed using a coordinate system. The z-direction is parallel to the longest extension of the plurality of first and second electrodes. X-direction is perpendicular to the extension of the z-direction, and y-direction is perpendicular to the x-z plane. The first and the second substrates are arranged in x-z plane. The longest extension of the first and second substrates may be in z-direction, but may also be in any direction in x-z plane.

A photovoltaic sheet according to the present invention comprises a first and a second flexible substrate, wherein the first and the second flexible substrates are at least partially superimposed. The photovoltaic sheet further comprises a plurality of continuous first electrodes arranged in physical contact with the first substrate, wherein each of the first electrodes has a longitudinal extension in substantially z-direction, and wherein the plurality of first electrodes is spaced in substantially x-direction being perpendicular to the z-direction, and a plurality of continuous second electrodes arranged in physical contact with the second substrate, wherein each of the second electrodes has a longitudinal extension in z-direction, and wherein the plurality of second electrodes is spaced in substantially x-direction being perpendicular to z-direction. Further, said plurality of first electrodes comprises of a first pair of outmost electrodes, and the electrodes of said plurality of first electrodes are substantially centered around a first center line extending in said z-direction. Also, said plurality of second electrodes comprises of a second pair of outmost electrodes, and the electrodes of said plurality of second electrodes are substantially centered around a second center line extending in said z-direction. In more detail, said plurality of first and second electrodes each consists of two outmost electrodes and a set of intermediate electrodes, where the two outmost electrodes are arranged on a respective side of said intermediate electrodes By the term "continuous" is herein meant that each electrode extends without or substantially without gaps in z-direction. The plurality of the first and the second electrodes are arranged between the first and second substrates, and at least one active layer is arranged between the plurality of first electrodes and the plurality of second electrodes.

The photovoltaic sheet according to the present invention further comprises a set of outmost electrodes consisting of said first pair of outmost electrodes and said second pair of outmost electrodes.

The photovoltaic sheet according to the present invention further comprises at least two photovoltaic modules, each photovoltaic module comprising: a pair of connectors comprising a first and a second electronically conductive connector, wherein a first terminal portion of said first electrically conductive connector is arranged in physical contact with a first outmost electrode in said set of outmost electrodes, and a first terminal portion of said second electrically conductive connector is in physical contact with a second outmost electrode in said set of outmost electrodes, said first and second outmost electrodes being arranged on opposite sides of a geometrical plane coinciding with said first and second center lines.

Each photovoltaic module according to the present invention further comprises at least one continuous frame of a first non-conductive adhesive material arranged between said respective plurality of continuous first electrodes and second electrodes and arranged between the first and the second substrate adhering the first and second substrates to each other. The continuous frame extends across at least a portion of each electrode of said plurality of first electrodes and across at least a portion of each electrode in said plurality of second electrodes. Moreover, the continuous frame frames a respective portion of said plurality of first electrodes and a respective portion of said plurality of second electrodes; wherein said respective portion of said first plurality of first electrodes preferably comprises a portion of each one of the intermediate electrodes, and wherein said respective portion of said plurality of second electrodes preferably comprises a portion of each one of the intermediate electrodes. For each connector in said pair of connectors, the continuous frame may be arranged between at least a portion of that connector and one of said first and second flexible substrates. With reference to this invention, the term "at least a portion of" is understood to comprise both the instance "only a portion of" (i.e. a sub part) as well as the instance "the whole of". In other words, if item B covers at least a portion of item C, this comprises both the instance when item B covers only a portion of item C as well the instance when item B covers the whole of item C.

Providing such a frame before lamination is contra intuitive, since applying a frame of adhesive before the lamination step may be expected to increase the separation between the layers of the solar cell module, thus compromising its electrical properties durability and/or lifetime.

By the term "busbar" is understood a conductor in physical and electrical contact with the outmost portions of the outmost electrodes of the plurality of first and second electrodes, and the busbar normally comprises the first terminal portion. The surface area of the outmost electrode that shares a common interface with the busbar or first terminal portion may be referred to as "extended electrode". At least a portion of each connector of the pair of connectors may be extending outside the at least one frame of the first adhesive material. Alternatively, the connector may be covered by the first adhesive material.

The portion of the outmost electrode being in contact with a busbar or first terminal portion will hereinafter be referred to as "electrode connection portion".

The first and/or the second flexible substrates may be of polyethylene terephthalate (PET) or any other suitable material. The first and/or the second substrate may be of the same material or of different materials.

The first and the second flexible substrates are at least partially superimposed. By the term "at least partially superimposed" is meant that one of the first and the second substrates comprises at least one portion being arranged above the other in y-direction being perpendicular to x-z plane. The first and second substrates are spatially separated from each other by intermediate layers, examples of such spatially separating layers are adhesive(s) and the first and second electrodes. According to one embodiment the superimposed area of the first and second substrates are fully separated from each other. Alternatively, the superimposed area of the first and second substrates comprises at least one portion were the first and second substrates are fully separated from each other and at least one portion where the substrates are in contact with each other. Preferably, the superimposed area of the first and/or second substrates constitute at least 80% of the total area of the respective flexible substrate.

The first and a second flexible substrate may have a longitudinal extension in z-direction and a transverse extension in x-direction being perpendicular to the z-direction. The longest extension of the first and/or the second substrate may be for example 0,5 m, or 1 m, or 5 m, or 10 m up to several hundred meters long.

The thickness of the first and/or the second substrate in y-direction may be at least 10 µm or at least 50 µm or at least 100 µm, additionally, or alternatively the thickness of the first and/or the second substrate in y-direction is at most 50 µm or at most 100 µm or at most 200 µm.

The photovoltaic sheet of the present invention may further comprise a first lateral portion and a second lateral portion, wherein the first and the second lateral portions are spaced apart in the direction being transversal to the direction of the longest extension of the first and/or the second substrate.

As mentioned above, the photovoltaic sheet further comprises a plurality of first electrodes arranged in physical contact with the first substrate, and a plurality of second electrodes arranged in physical contact with the second substrate. By the term "in physical contact" is meant that the plurality of first and second electrodes is arranged directly on the first substrate without any additional layer therebetween. The plurality of first electrodes may be arranged off-set relative the plurality of second electrodes in x-direction. In relation to this invention, when the plurality of first/(second) electrodes are arranged off-set the plurality of second/(first) set of electrodes, each electrode in the plurality of first/(second) set of electrodes is aligned with a respective gap between the electrodes of the plurality of second/(first) electrodes in y-direction. This arrangement may also facilitate the production of such photovoltaic modules.

Preferably, the longitudinal extension of the plurality of first and second electrodes in z-direction is continuous, i.e. no gaps are present between the electrodes in z-direction.

It shall be understood that the expression "A covers B in at least one direction" means that any imaginary line, parallel to and directed in that one direction, will run through A before running through B. For example, a line normal to the x-z plane, i.e. directed in the y-direction, will first run through one of the plurality of first electrodes before it runs through a gap between two of the plurality of second electrodes. In other words, where there is a gap at one of the substrates there is an electrode at the opposite substrate. Alternatively, each electrode of the plurality of the first electrodes may be aligned with an electrode of the plurality of the second electrodes in y-direction.

The width of each electrode of the plurality of first electrodes in x-direction may be greater that the width of the gap between two adjacent electrodes of the plurality of first electrodes in x-direction. The same may be true for the plurality of second electrodes.

Moreover, it shall be understood that the plurality of first electrodes and the plurality of second electrodes may be arranged in an interleaved manner wherein all, or all but one, or all but two of the plurality of first electrodes fully cover a respective one of the plurality of gaps between the plurality of second electrodes and wherein all, or all but one, or all but two of the plurality of second electrodes fully cover a respective one of the plurality of gaps between the plurality of first electrodes.

A center of a gap in the x-direction may aligned with a central portion of a covering electrode in the x-direction or a central portion of an electrode in the x-direction is aligned with a center of a gap in the x-direction between electrodes on the opposite substrate portion.

The plurality of first and second electrodes are arranged such that an electrical connection between the electrodes is achieved via the continuous active layer or via the first and second continuous active layers, which will be described in greater detail below.

The plurality of first electrodes may comprise 3-50 electrodes, or 5-40 electrodes, or 5-30 electrodes, or 10-30 electrodes. The plurality of second electrodes may comprise 2-50 electrodes, or 5-40 electrodes, or 10-30 electrodes. The plurality of first and second electrodes may comprise the same or different number of electrodes.

The width in the x-direction of each electrode of the plurality of first and second electrodes may be 1-20 mm, or at least 2-15 mm, or 2-10 mm. The widths of each electrode within the plurality of first and second electrodes may be same or different.

The length of the plurality of first and second electrodes in z-direction may be the same as the length of the first and/or the second substrate. Alternatively, the length in the z-direction of each of the plurality of first and second electrodes may be at least 70 %, or at least 80 %, or at least 90% of the length of the substrate portion in the same direction. The length in z-direction of each electrode of the plurality of first and second electrodes may be at least 10 mm, or at least 20 mm, or at least 50 mm, or at least 100 mm, or at least 300 mm, or at least 500 mm, or at least 1000 mm. Further, the length of each electrode of the plurality of first and second electrodes in z-direction may be at least two times, or at least three times, or at least five times the width of each electrode of the plurality of first and second electrodes in x-direction. For example, if the width in the x-direction of one of the electrodes is 20 mm, the length in the z-direction of that electrode may be at least 40mm, or at least 60 mm, or at least 100 mm. According to another example, if the width in the x-direction of each of the plurality of first or second electrodes is 9 mm, then the length in the z-direction each of the plurality of first or second electrodes may be at least 300 mm.

The thickness of the plurality of first electrodes and the plurality of second electrodes in the y-direction may be at least 20 nm or 50 nm, and/or at most 300 nm or 2000 nm.

The plurality of first and second electrodes may comprise an electrode material that may be a conducting organic compound, a metal, a metal oxide or combinations thereof. The conducting organic compound may for example be a conducting organic small molecule or a conducting polymer. The conducting polymer may for example be poly(3,4-ethylenedioxythiophene) polystyrene sulfonate (PEDOT:PSS) or variants thereof, e.g. PEDOT:PSS PH1000. The metal may be chosen from a list comprising but not limited to: aluminum (Al), chromium (Cr), titanium (Ti), cupper (Cu), gold (Au) and silver (Ag). The metal oxide may be for example indium tin oxide (ITO) and aluminum zinc oxide (AZO). According to the present invention, at least one of the plurality of first and second electrodes may comprise one or more layers. For example, the electrode may be an ITO/metal/ITO (IMI) electrode comprising a first layer of ITO, a second layer of a metal and a third layer of ITO. The electrode may for example comprise ITO/Ag/ITO.

It shall be understood that the plurality of first and second electrodes may extend in any direction in the x-z plane over the first and second substrates and they may have linear or non-linear extension, i.e. straight, curved, zig-zag or the like. They may also be parallel or non-parallel. Moreover, it shall be understood that they may have substantially the same width throughout the entire length in z-direction, or they may have a varying width throughout the entire length in z-direction. All the electrodes of the plurality of first and second electrodes may have the same width or different electrodes may have different widths.

The plurality of first and second electrodes may be provided by a variety of deposition techniques, for example they may be provided by means of thermal evaporation, sputtering, spray-coating, printing or coating such as e.g. slot-die coating. The plurality of first electrodes and the plurality of second electrodes may be provided by the same deposition technique or by different deposition techniques.

The plurality of first and second electrodes may be provided, e.g. evaporated, spray-coated, or printed, by an additive or subtractive method. When using an additive method, the electrodes are provided directly as stripes on the first and the second substrate portion respectively. A subtractive method comprises a first step where the electrode material is provided all over the substantially full surface area of the first and/or second substrate portion and a second step which comprises removing the electrode material so that the plurality of first and second electrodes are formed respectively, e.g. by laser ablation. By using such a subtractive method, the area of gaps which is formed in between each of the plurality of first and/or second electrodes may be decreased, i.e. the distance between each of the plurality of first and/or second electrode may be decreased. Decreasing the area of the gaps allows for a larger photovoltaic photo-active area and hence the capacity of the photovoltaic module will increase. Alternatively, the second step of the subtractive method, e.g. laser ablation, may be performed after the step of laminating. Hence, the second step, e.g. laser ablation may be done through the PET substrate.

According to at least one example embodiment of the invention the width in the x-direction of the gaps may be in the range of 0.01-10 mm, or preferable in the range of 0.02-5 mm, or even more preferably 0.05-3 mm. The width in the x-direction of the gaps may vary depending on the method with which the plurality of first and second electrodes are provided. If the electrodes are provided with an additive method, the width of the gaps in the x-direction may be in the range of 0.5-3 mm, e.g. 1 mm. If the electrodes are provided with a subtractive method, e.g. using laser ablation, the width of the electrodes in x-direction may be in the range of 0.01-0.2 mm, e.g. 0.05 mm.

A plurality of first gaps may separate the individual electrodes in the plurality of first electrodes from each other in x-direction; and a plurality of second gaps may separate the individual electrodes in said plurality of second electrodes from each other in x-direction.

It is to be understood that each electrode in said plurality of first and second electrodes may have a first and a second end portion spatially separated along the longest extension of said electrode.

The purpose of the active layer according to the present invention is to provide photovoltage as well as photocurrent when illuminated with photons with sufficient energy above its optical bandgap that can be extracted as electric power and may also be referred to as "photoactive layer".

The combined thickness of the active layer in the photovoltaic module in y-direction may be at least 30 nm or 80 nm and/or at most 350 nm or 1000 nm. As mentioned above, the active layer may be applied on the first substrate portion, on the second substrate portion or on both the first and the second substrate portions. When the active layer is applied on both the first and the second substrate portions, the sum of the thickness of the active layer in y-direction on the first substrate portion and on the second substrate is the combined thickness.

The continuous or discontinuous active layer or the first and the second continuous or discontinuous active layer may comprise a compound which absorbs wavelengths within the range of 350-1100 nm. It may for example absorb light within the visual spectrum, i.e. wavelengths within a range from 400 nm to 700 nm.

It shall be understood that a continuous active layer is an active layer that covers both the plurality of gaps between electrodes and the plurality of first or second electrodes in x-z plane such that the photo active area. Moreover, it shall be understood that the first continuous active layer covers both the plurality of first electrodes and the plurality of gaps between those electrodes. In the same manner, the second continuous active layer covers both the plurality of second electrodes and the plurality of gaps in between those. In other words, it shall be understood that the continuous active layer or the first and the second continuous active layer are provided globally over the plurality of first and second electrodes and gaps between each of the plurality of first and second electrodes. The continuous active layer or the first and/or the second continuous active layer may comprise printed and/or coated semiconductors. In particular, the active layer may be an organic active layer and may comprise a donor material and/or an acceptor material. According to at least one embodiment, the active layer is a hybrid organic-inorganic material, such as halide perovskites, in particular lead/tin halide perovskites. Further, the active layer may comprise quantum dot based materials, such as lead sulfide (PbS) colloidal quantum dots (CQD).

All the active layers in the photovoltaic sheet may be organic active layers. The donor material may be a semi-conducting polymer or a semi-conducting small organic molecule. The semi-conducting polymer may for example be any semi-conducting polymer and their derivatives, including but not limited to:, polythiophenes, polyanilines, polypyrroles, polycarbazoles, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly( cyclopentadithiophene oxide)s, polythiadiazoloquinoxaline, polybenzoisothiazole, polybenzothiazole, polythienothiophene, poly(thienothiophene oxide), polydithienothiophene, poly(dithienothiophene oxide)s, polytetrahydroisoindoles, and copolymers thereof. The semi-conducting polymer may also be an iso-indigo-based polymer. In more detail, the semi-conducting polymer may for example be: P3HT, PTB7, TQ1, P3TI, PCDTBT, or PffBT4T-2OD. The semi-conducting small molecule may for example be a molecule comprising at least one benzodithiophene group, e.g. DRTB-T or BDT3TR. The acceptor material may for example be a semi-conducting polymer or a semi-conducting small molecule. The semi-conducting polymer may for example be N2200 or PNDI-T10. The semi-conducting small organic molecule may for example be a fullerene, a fullerene derivative or any other semi-conducting small molecule such as (5Z,5'Z)-5,5'-{(9,9-dioctyl-9H-fluorene-2,7-diyl)bis[2,1,3-benzothiadiazole-7,4-diyl(Z)methylylidene]lbis(3-ethyl-2-thioxo-1,3-thiazolidin-4-one) (FBR), or 3,9-bis(2-methylene-(3-(1, 1-dicyanomethylene)-indanone))-5,5,11,11-tetrakis(4-hexylphenyl)-dithieno[2,3-d:2',3'-d']-s-indaceno[1,2-b:5,6-b']dithiophene) (ITIC). The fullerene derivative may be the phenyl-C61-butyric acid methyl ester (PC61BM), the phenyl-C71-butyric acid methyl ester (PC71BM), the indene-C60-bisadduct (ICBA), O-IDTBR or IC-C6IDT-IC.

Examples of perovskite material used in the active layer of the present invention include but are not limited to methylammonium lead trihalide (CH₃NH₃PbX₃, where X is a halogen ion such as iodide, bromide or chloride), formamidinium lead trihalide (H₂NCHNH₂PbX₃) or methylammonium tin triiodide (CH₃NH₃Snl₃). With respect to perovskite materials, cat ions are not limited to only organic ones but can also contain metal ions such as cesium (Cs) preferably where the constituent number of different cat ions is more than 2, such as in a 'triple' cat ion perovskite. Further still, fully inorganic perovskites such as CsPbl2Br is a possible realization of the perovskite active material.

Further examples of quantum dot materials include but are not limited to: Cadmium Selenide (CdSe), Lead Selenide (PbSe) and Silver Bismut Sulfide (AgBiS2).

The mixture of a donor and an acceptor material may be provided as a bulk-heterojunction.

Additionally, the electrodes, the pair of connectors, the active layer maybe provided with further materials and further deposition techniques than mentioned above, the details of which can be found in document EP 3 364 474 A1 incorporated herein by reference.

As mentioned above, the photovoltaic sheet of the present invention further comprises at least one continuous frame of a first non-conductive adhesive material arranged between the first and the second substrate, which frame is arranged to frame at least one photovoltaic module. By the term "frame" is to be understood as "an enclosing border", i.e. a line forming a border that encloses a photovoltaic module. In other words, each the frame of the first adhesive material defines the boundaries of the respective photovoltaic module.

Each of the connectors in said pair of connectorsis arranged in electrical connection with one electrode of the plurality of first and second electrodes. At least a portion of each of the connectors in said pair of connectors may be extending outside the at least one frame of the first adhesive material.

According to the present invention, the frame of the first adhesive material comprises at least one portion being arranged between the plurality of first and second electrodes and preferably extending across each one of said plurality of first and second electrodes. Such a positioning of the frame of the first adhesive material has several advantages. First of all, the portion of the frame of the first adhesive material arranged between the plurality of the first and the second electrodes forms a line which separates and seals the photovoltaic modules and may be used for placing a cutting line during singulation, as will be described below. Further, the portion of the frame of the first adhesive material arranged between the plurality of the first and the second electrodes separates the first and the second substrates from each other, such that the risk of short circuit and electric breakdown is avoided.

The pair of connectors is provided for connecting the photovoltaic modules to each other or to a load. The connectors in each pair of connectors are preferably spaced apart in x-direction, each connector being in electrical contact with a portion of the respective outermost electrode of the plurality of first and/or second electrodes in x-direction. Such a portion of the outmost electrode is hereinafter referred to as "electrode connection portion".

According to one example, the each connector in said pair of connectors comprises a first layer of an electrode material that has been evaporated, spray-coated, or printed, and a busbar connected thereto. The at least a portion of the connector or busbar may for example be made from graphite or silver and may be screen printed. The electrode connection portion may further comprise other printed or laminated layers. The connectors or busbars may be divided in two parts, where the inner part may be used as one of the electrodes in one photovoltaic cell comprised in the photovoltaic module and the outer part is used for connecting the photovoltaic module to a load when the photovoltaic module is in use. The outer part of the first terminal portion of the connector or the outer part of busbar is normally not covered by the active layer.

The electrode connection portion may comprise an electrode material which may comprise a conducting organic compound, a conducting carbon compound, a metal, a metal oxide or combinations thereof. The conducting organic compound may for example be a conducting organic small molecule or a conducting polymer. The conducting polymer may for example be poly(3,4-ethylenedioxythiophene) polystyrene sulfonate (PEDOT:PSS) or variants thereof, e.g. PEDOT:PSS PH1000. The conducting carbon compound may be provided as a carbon paste or as graphite or graphene. The metal may be chosen from a list comprising but not limited to: aluminium (Al), chromium (Cr), titanium (Ti), cupper (Cu), gold (Au) and silver (Ag). The metal oxide may be chosen from a list comprising but not limited to: indium tin oxide (ITO) and aluminium zinc oxide (AZO). According to at least one example embodiment of the invention the metal is provided as an ink where the metal is provided as nanoparticles, e.g. nano-spheres or nano-rods. According to at least one example embodiment of the present invention, the electrode connection portion may comprise one or more layers. For example, the electrode connection portion may be an ITO/metal/ITO (IMI) electrode comprising a first layer of ITO, a second layer of metal and a third layer of ITO. The electrode may for example comprise ITO/Ag/ITO. The electrode material may be the same electrode material as for the plurality of the first or second electrodes or it may be a different electrode material.

The photovoltaic sheet of the present invention may comprise several pairs of connectors or busbars distributed along the extension of the electrodes in z-direction.

According to one example, the photovoltaic module has the same configuration as explained in EP 3 364 474 from the same applicant, but many other configurations are possible as explained in more detail below. According to one general example the photovoltaic module comprises a first set of electrode stripes arranged on a first substrate portion and a second set of electrode stripes arranged on a second substrate portion, wherein the stripes in each set are separated from each other by gaps. In the final module, the electrodes are sandwiched between the first and second substrate, and an active layer is sandwiched between the first and second set of electrodes, wherein the photovoltaic module in use comprises both anode and cathode electrodes.

The shape of the frame of the first adhesive material may form a rectangle, a circle, an ellipse, a rhomb, a parallelogram, a trapezium or the like. Moreover, the line forming the frame of the first adhesive material may be straight line, wave-shaped line, curved line, zig-zag line or the like.

The frame of the first adhesive material may comprise at least two separate substantially parallel lines. Each one of the lines may only partly frame the photovoltaic module, while together they fully frame the photovoltaic module. Alternatively, one or both of the lines may fully frame the photovoltaic module. The first and the second lines may be of the same or different adhesive materials. One of the lines may e.g. consist of a hydrophobic adhesive material designed to decrease the passage of moisture therethrough; and the other of the lines may e.g. consist of an adhesive material with low oxygen permeability designed to decrease the passage of oxygen therethrough. A frame line may also comprise interleaved or alternating portions of hydrophobic adhesive material and adhesive material with low oxygen permeability along the extension of the line.

The smaller the thickness of the frame of the first adhesive material in y-direction, the smaller the passage into the photovoltaic module. The broader the adhesive in x and/or z-direction, the better the adhesive properties.

Generally, the thickness of the frame of the first adhesive material in y-direction should be sufficient for providing an adequate adhesion strength such that the photovoltaic sheet is robust and withstands handling during installation and use. On the other hand, the thickness of the first adhesive material should be low enough not to compromise electric contact between the plurality of the first and second electrodes and the active layer or to avoid that the adhesive overflows when performing the act of lamination or adhesion of the photovoltaic sheet substrates. Further, the thickness of the first adhesive material should be low enough to prevent air being trapped within the photovoltaic module.

The thickness of the frame of the first adhesive material in y-direction should exceed the surface roughness of the substrate in order to obtain adequate bonding strength. Further, the thickness of the first adhesive material in y-direction should have at least the same thickness as the thickness of the components applied to the substrate, e.g. the thickness of the plurality of the electrodes or the combined thickness of the plurality of electrodes and the active layer. The thickness of the first adhesive material may be at least 10 times the thickness of the stack of layers applied to the substrate. Further, the thickness of the first adhesive material may be below 100 times the thickness of the stack of layers applied to the substrate. In particular, the thickness of the first adhesive material may be below 10 µm.

In accordance with the present invention, the thickness of the frame of the first adhesive material in y-direction in the photovoltaic sheet after the lamination or adhesion step may be from 10 nm to 50 µm, preferably from 50 nm to 30 µm, more preferable from 100 nm to 10 µm. These values refer to the thickness of the adhesive layer after the lamination and after drying of the adhesive.

The thickness of the frame of the first adhesive material may be uniform throughout the entire extension of the frame in x-z plane, or may vary throughout the extension of the frame in x-z plane.

Drying of the adhesive is to be understood as the adhesive composition undergoing evaporation of solvent. Drying therefore entails that the amount of dry substance in the adhesive increases.

"After drying" is to be understood as the point in time when the drying process is completed, i.e. when the first adhesive material is tactilely dry. Normally, there is a more rapid initial decrease of solvent content followed by a substantially steady state. Preferably, the thickness of the adhesive layer referred to above is determined at the steady state.

Drying may be achieved in a separate step which includes heating of the photovoltaic sheet. Drying should be completed before lamination occurs.

According to the present invention, the adhesive material after lamination or adhesion step may undergo a change in its thickness dependent on the compressibility of the adhesive. Another factor that may influence the dimensions of the adhesive in the laminated product is e.g. vapour pressure and the wetting of the adhesive on the substrate and effects related thereto.

According to the present invention, the frame of the first adhesive material may be formed of one or more lines each having a respective direction of extension, wherein the width of each line in a direction parallel with the first and second substrate and orthogonal to the direction of extension of the line may be at least 10 µm, at least 100 µm or at least 1 mm or at least 5 mm. Additionally or alternatively, the width of each line in a direction parallel with the first and second substrate and orthogonal to the direction of extension of the line may be at most 10 mm at most 5 mm or at most 1 mm or at most 0.1 mm.

The frame of the first adhesive material may comprises at least two transverse portions extending in a direction being transversal to the z-direction and being arranged between the plurality of first electrodes and the plurality of second electrodes.

According to the present invention, the continuous frame of the first adhesive material may comprise at least two longitudinal portions arranged at the first and the second lateral portion of the photovoltaic sheet, respectively, and extending in substantially z-direction. The at least two longitudinal portions and the at least two transverse portions of the frame of the first adhesive material may thus frame at least one photovoltaic module.

The extension of the frame of the first adhesive material in x-z plane may vary. Generally, the extension of the frame of the first adhesive material should correspond to the desired dimension of the photovoltaic module being framed by the frame.

It should be noted that the dimensions of the frame of the first adhesive material presented above relate to the dimensions after lamination, i.e. when the photovoltaic sheet is completed. Obviously, the dimensions of the frame of the first adhesive material when it is applied to the first and/or the second substrate prior to lamination of the first and the second substrate to each other will not be the same, since the first adhesive material will be deformed during lamination. Generally, the length and the width of frame of the first adhesive material prior to lamination should be less that the dimensions given above, while the thickness of frame of the first adhesive material prior to lamination should be greater.

The photovoltaic sheet may comprise a plurality of frames. Each two adjacent frames may have at least one common portion. In particular, a respective transverse portion of two adjacent frames of the plurality of frames is formed of a continuous layer of adhesive material and/or at least partly coincide.

The first adhesive material may be deposited as an adhesive solvent or by transfer printing.

The first adhesive material may be colored with any colour e.g. black, red, white or green so as to create an ornament or an easily observable delimitation on the first and/or the second substrate with aesthetic appearances.

A plurality of discontinuous portions of the first adhesive material or another adhesive material being different from the first adhesive material may be spatially arranged between the first and the second substrate portion within at least one of the photovoltaic modules. By the term "within the photovoltaic module" it should be understood the space inside the inner area a photovoltaic module. In other words, the term "within the photovoltaic module" means the area being framed by the frame of the first adhesive material. When there is adhesive material present within the photovoltaic module, the ratio between covered and uncovered area within each photovoltaic module may be at least 1% or at least 10% or at least 20% and/or at most 40 % or at most 30 % or at most 25%.

By providing at least one of photovoltaic modules with discontinuous portions of a non-conductive first adhesive material or another adhesive material being different from the first adhesive material which is spatially arranged within the respective photovoltaic module, the lifetime and mechanical durability of the photovoltaic sheet further increases. This is particularly interesting for creating large areas of flexible photovoltaic sheets wherein breakage of the top and bottom substrates of the photovoltaic sheet may occur more frequently due to mechanical strain or ambient temperature and humidity conditions.

According to the present invention, each of the at least one photovoltaic modules may be framed by the frame of the first adhesive material. As mentioned above, the frame of the first adhesive material forms a border around the photovoltaic module. When each of the photovoltaic modules is framed by the frame of the first adhesive material, two adjacent photovoltaic modules may have a common frame portion.

The first adhesive material may be optically transparent or semi-transparent within a wavelength range of the at least one active layer.

The first adhesive material may comprise thermoplastic polymers, e.g. thermoplastic polyurethane, polypropylene, polybutylene, polyvinyl butyral, polyvinyl acetate, ethyl vinyl acetate, polystyrene butadiene copolymers or ethylene vinyl alcohol copolymers and combinations thereof. Further, the first adhesive material may comprise UV curing polymers; such as acrylic and/or epoxy based UV curing polymers.

Moreover, the first adhesive material may comprise a pressure-sensitive adhesive (PSA). The PSA may be selected from a group consisting of acrylate polymers, natural rubber, synthetic thermoplastic elastomer and silicone rubber.

PSA exhibits advantageous adhesion properties towards the layers of the solar sheet module, in particular towards the active layer, ensuring a sufficient adhesive force. The PSA is soft, which allows it to distribute itself in a smooth manner across the surface to which it is applied. PSA is easy to disperse in a solvent and subsequently print as a pattern. Finally, PSA may be used for simultaneous lamination of the layers and providing insulation of the opposing electrodes.

The first adhesive material may be a hydrophobic adhesive material. Such hydrophobic adhesive materials provide a photovoltaic sheet having improved moisture resistance, which is particularly advantageous when the photovoltaic sheet is used in an outdoor environment. Further, this has the advantage of protecting the inner part of the photovoltaic modules from the outside moisture or keeps the inner part of the photovoltaic modules at a slightly elevated or lower humidity compared to the ambient humidity. This adjusted working humidity of the inner part of the photovoltaic modules may be advantageous for manufacturing photovoltaic sheets for use in different climate conditions and thermal cycles.

The first adhesive materials may partly or fully consist of an adhesive material with low oxygen permeability. Additionally, the adhesive material may serve as an isolation layer between the inner part of the photovoltaic module and the outer part of the photovoltaic module which may be immediately exposed to outside environment. Thus, the adhesive material may protect the photovoltaic modules from penetration of undesired moisture, oxygen, dust particles or any type of aerosol particulates which may deteriorate the functionality of the photovoltaic modules.

The photovoltaic sheet according to the present invention may comprise an electron transport layer (ETL) being arranged on the plurality of first electrodes and/or on the plurality of second electrodes. In other words, the **ETL** is arranged between the active layer and one of the plurality of first and/or second electrodes. The frame of the first adhesive material may then comprise at least one portion being arranged between the electron transport layer and the at least one active layer.

The photovoltaic sheet according to the present invention may comprise a hole transport layer (HTL) being arranged on the plurality of first electrodes and/or on the plurality of second electrodes. In other words, the ETL is arranged between the active layer and one of the plurality of first and second electrodes. The frame of the first adhesive material may in this case comprise at least one portion being arranged between the hole transport layer and the at least one active layer.

In particular, both the ETL and the HTL may be arranged at each of the plurality of the first and second electrodes. In this case, the ETL and the HTL are arranged alternatingly in x-direction. Moreover, when the photovoltaic module is assembled by superimposing the first and the second substrate portions, each comprising the plurality of first and second electrodes, respectively, as well as the ETL and HTL**,** the ETL on the plurality of first electrodes should be arranged over HTL on the plurality of second electrodes in y-direction, and vice versa.

At least one of the at least a pair of busbars may comprise a contact bridge, which may extend outside of the frame of the first adhesive material. The contact bridge may be in electrical connection with the portion of the busbar which is arranged between the substrate and the outermost electrode, , and the contact bridge may have a longitudinal extension in the x- and/or z-direction. In more detail, the contact bridge may have a shorter portion extending in the x-direction and a longer portion extending in the z-direction. This longer portion of the contact bridge may run parallelly to the outermost electrode and may be separated from the busbar by a distance X in x-direction, thus forming an intermediate substrate portion. The terminal end of the contact bridge will hereinafter be referred to as a contact point. The contact point may be exposed to ambient by removing the flexible substrates, and may be used for connection of the photovoltaic module to other photovoltaic modules or a load. Such a contact bridge may be applied to the first and/or second substrate simultaneously with the application of the plurality of first and/or second electrodes.

Preferably, all the photovoltaic modules in a photovoltaic sheet may be provided with at least one contact bridge. The contact bridge according to the present invention is arranged in order to create a distance between the photovoltaic module and the contact point. Such a distance may be necessary when it is desirable to protect the photovoltaic module, since the contact bridge allows placing the opening which is created in the first and/or a second substrate when the contact point is exposed at a distance from the photovoltaic module itself. Such a distance provides additional protection of the photovoltaic module from dirt and moisture, which may be advantageous when the photovoltaic module is installed in a harsh outdoor environment, such as a window or a car chassis. Further, the intermediate substrate portion may be removed, e.g. by cutting, thus improving separation between the contact point and the photovoltaic module. The contact bridge may be a printed conductor. The contact bridge should have good conducting properties and should be stable and inert. The contact bridge may comprise silver particles.

According to at least one embodiment, said first and second electronically conductive connectors further comprises a second terminal portion and an intermediate portion arranged between said first and second terminal portions. The intermediate portion of said first and second electronically conductive connector is arranged between, and optionally in direct contact with, one of said first and second flexible substrates and a portion of said continuous frame of adhesive material. The second terminal portion of said first and second electrically conductive connector is preferably arranged outside said continuous frame of said first adhesive material and optionally exposed so as to enable for connection of the photovoltaic module to other photovoltaic modules or a load.

According to at least one embodiment, said first terminal portion is elongated and extends in said z-direction, and both said first and second electrically conductive connectors comprises a substantially U- or V-shaped portion which substantially U- or V-shaped portion partly encircles an elongated portion arranged to the side of said plurality of first and second continuous electrodes. The substantially U- or V-shaped portion may e.g. encircle an adhesive adhering two substrates to each other. The substantially U- or V-shaped portion comprises two elongated portions joined by a linking portion, wherein one of said elongated portion coincides with said first terminal portion and the other elongated portion preferably extends in a direction substantially parallel with said first elongated portion. The elongated portions being e.g. at least 5 times longer than the linking portion. According to one example said elongated portions are separated by a distance within the range of 0.1 - 50 mm in the x-direction. According to one example, said elongated portions are separated by a distance of at least 0.1 mm, or at least 0.5 mm, or at least 1 mm, or at least 3 mm, or at least 5 mm. Additionally or alternatively, said elongated portions are separated by a distance of at most 50 mm, or at most 20 mm, or at most 10 mm, or at most 3 mm. The linking portion may be straight or curved. According to one example, the other of said elongated portions extends in a direction which deviates from said z-direction by α degrees, where α is in the rage of 0 to 20 degrees and preferably within the range of 0 to 10. Additionally or alternatively, α is larger than 2 degrees or larger than 5 degrees and/or smaller than 15 degrees or smaller than 6 degrees.

The substantially U- or V-shaped portion may be a printed. The substantially U- or V-shaped portion preferably have good conducting properties and is preferably stable and inert. The substantially U- or V-shaped portion may comprise silver particles.

The partly encircled elongated portion arranged to the side of said first and second plurality of continuous electrodes, and the separation distance between the first terminal portion and the second terminal portion is advantageous as it protects the said first and second plurality of continuous electrodes from e.g. from dirt and moisture which may enter into the module via said second terminal portion when exposed to ambient so as to enable connection further circuits or loads.

Further, the partly encircled elongated portion arranged to the side of said first and second plurality of continuous electrodes the intermediate substrate portion may be fully or partly removed or disrupted, e.g. by cutting, thus improving separation between the second terminal portion and the photovoltaic module.

The photovoltaic sheet according of the present invention may be configured to be cut along at least one cutting line in x-z plane to form at least
one photovoltaic module. The cutting line may coincide with at least a portion of the frame of the adhesive material. In particular, the cutting line may coincide with at least one transverse potion of the frame of the first adhesive material. Cutting may be performed by die cutting, laser cutting, or any other suitable industrial cutting method.

The photovoltaic module, thus formed by cutting the photovoltaic sheet, comprises a first substrate portion of a first flexible substrate and a second substrate portion of a second flexible substrate, wherein the first and the second substrate portions are at least partially superimposed.

The photovoltaic module further comprises a plurality of first electrodes arranged in physical contact with the first substrate portion, wherein each of the first electrodes has a longitudinal extension in substantially z-direction, and wherein the plurality of first electrodes is spaced in substantially x-direction being perpendicular to the z-direction. The photovoltaic module further comprises a plurality of second electrodes arranged in physical contact with the second substrate portion, wherein each of the second electrodes has a longitudinal extension in the z-direction, and wherein the plurality of second electrodes is spaced in substantially x-direction being perpendicular to the z-direction. The plurality of the first and the second electrodes is arranged between the first and second substrate portions.

The photovoltaic module according to the present invention further comprises at least a pair of connectors or busbars, each of which is in electrical connection with one electrode of the plurality of first and second electrodes, and at least one active layer arranged between the plurality of first electrodes and the plurality of second electrodes.

The photovoltaic module of the present invention further comprises at least one continuous frame of a first non-conductive adhesive material arranged between the first and the second substrate portions. The at least one frame of the first adhesive material frames the photovoltaic module, and least a portion of each of the pair of connectors or busbars is extending outside the at least one frame of the first adhesive material.

The present invention relates to a method for producing a photovoltaic sheet comprising at least one photovoltaic module, the method comprising the steps of:
a) providing a first flexible substrate and a second flexible substrate;
b) providing a plurality of first electrodes on the first flexible substrate and a plurality of second electrodes on the second flexible substrate; the first and the second electrodes extending in z-direction and being spaced in x-direction being perpendicular to the z-direction;
c) providing at least one pair of connectors orbusbars, each of which is in electrical connection with an electrode connection portion of one electrode of the plurality of first and second electrodes;
d) providing at least one active layer on the plurality of first electrodes and/or the plurality of second electrodes;
e) providing at least one continuous or discontinuous frame of a first non-conductive adhesive material on the first and/or the second substrate, such that the frame of the first adhesive material frames at least one photovoltaic module, the at least one photovoltaic module comprising a respective portion of said first plurality of first electrodes and/or a respective portion of said plurality of second electrodes and at least a pair of connectors or busbars;
f) laminating by means of heat and/or pressure the first and the second substrate together such that the first adhesive material adheres the first and second substrates to each other to form the photovoltaic sheet; such that the plurality of first and second electrodes is arranged between the first and second substrates; such that the at least one active layer is arranged between and in electrical contact with the plurality of first electrodes and the plurality of second electrodes, and such that the frame of the first adhesive material becomes continuous and comprises at least one portion being arranged between the plurality of first electrodes and the plurality of second electrodes.

According to the present invention, the plurality of the first and second electrodes is applied directly on the first and the second substrate, respectively, such that physical contact is created between the plurality of first electrodes and the first substrate, and the plurality of second electrodes and the second substrate, respectively.

Step e) above may comprise providing a plurality of continuous or discontinuous frames each framing a respective portion of said first or second electrodes, and wherein a respective portion of said adhesive material of two adjacent frames coincide and/or are formed of a continuous layer of said first non-conductive adhesive material.

Step e) above may occur before step d). In other words, the frame of the adhesive material may be applied on the first and/or the second substrate before the active layer is applied. Further, step b) and step c) may occur simultaneously. If the photovoltaic sheet comprises further layers, such as ETL and/or HTL described above, these layers may be provided in an additional step d'), which may occur between step b) and step f).

The active layer, the ETL, the HTL and the first adhesive material may be applied by a variety of deposition techniques, for example they may be provided by means of thermal evaporation, sputtering, spray-coating, printing or coating such as e.g. slot-die coating. The above-mentioned components may be provided by the same deposition technique or by different deposition techniques.

According to the method of the present invention, the frame of the first adhesive material may be discontinuous and the ratio between covered and uncovered area may be at least 1% or at least 10% or at least 20% and/or at most 40 % or at most 30 % or at most 25%. When the frame of the first adhesive material is discontinuous, it is important that the length, the width and the thickness of the frame as discussed above is selected such that the frame becomes continuous after step f), i.e. after lamination of the first and the second substrates together.

The step of providing a busbar or connector may further comprise the step of:
c') providing a contact bridge adjacent to and electrically connected with one of said outer electrodessuch that an elongated portion of said contact bridge preferably extends in a direction substantially parallel with said outmost electrode.

The contact bridge or connector may extend outside of the frame of the first adhesive material.

Step c') may occur simultaneously with step b) and/or step c).

According to the present invention, each frame frames a photovoltaic module, and the method may further comprise the step of:
g) after the lamination cutting the photovoltaic sheet along at least one cutting line extending in x-z plane to separate at least one photovoltaic module from the plurality of photovoltaic modules; wherein the cutting line preferably coincides with at least a portion of the frame of the first adhesive material.

As a result of step g), at least one photovoltaic module is formed, being framed by the frame of the first adhesive material. The frame of the first adhesive material framing a photovoltaic module preferably has a sufficient width such that the act of separating or cutting the photovoltaic module can be performed without destroying the adhering properties of the first adhesive material. Moreover, a separation can be provided in between two neighboring transverse or longitudinal portions of the first adhesive material which further facilitates cutting in between the adhesive lines. An advantage of cutting close to the adhesive is that the area of the module, and thus its environmental footprint, is reduced. An advantage of cutting more remote from the adhesive is increased mechanical stability of the lamination.

If the photovoltaic module formed in step g) requires additional protection against outer factors such as dirt and moisture, the method may further comprise the steps of:
h) providing a first and a second barrier substrate;
i) providing a second adhesive material on the first and/or the second barrier substrate;
j) arranging at least one of the photovoltaic modules on the first or the second barrier substrate;
k) laminating the first and the second barrier substrates together such that the at least one photovoltaic module is arranged between the first and the second barrier substrate.

The barrier substrate encapsulates the photovoltaic module, thus providing additional service life and functional stability. The second adhesive material may comprise thermoplastic polymers, e.g. thermoplastic polyurethane, polypropylene, polybutylene, polyvinyl butyral, ethyl vinyl acetate, polystyrene butadiene copolymers or ethylene vinyl alcohol copolymers and combinations thereof. Further, the second adhesive material may comprise UV curing polymers; such as acrylic and/or epoxy based UV curing polymers.

Moreover, the second adhesive material may comprise a pressure-sensitive adhesive (PSA). The PSA may be selected from a group consisting of acrylate polymers, natural rubber, synthetic thermoplastic elastomer and silicone rubber. The second adhesive material may be same as or different from the first adhesive material.

Further, the method of the present invention may comprise step e') of providing at least one of the at least one photovoltaic modules with a plurality of discontinuous portions of the first non-conductive adhesive material or another adhesive material spatially arranged within the photovoltaic module. In this case, step e') should occur after step b) and before step f) and may occur simultaneously with step e).

It should be noted that the plurality of first and second electrodes, the active layer, the ETL, the HTL are preferably provided in the form of continuous layers in z-direction.

According to the present invention, the photovoltaic sheet is provided having improved lifespan and mechanical stability and durability, which is particularly important when the photovoltaic sheet is a thin film printed photovoltaic sheet having large area being produced by means of roll-to-roll processing, including roll-to-sheet and also sheet-to-sheet processing.

Although adding to the separation between the substrates and thereby increasing the probability of deficient contact between the layers, the inventors have made the realization that providing a frame of the first adhesive material on the first and/or second substrates of the photovoltaic sheet such that the frame of the first adhesive material frames the photovoltaic module and comprises at least a portion being arranged between the plurality of first and second electrodes normally improves the functionality of the photovoltaic modules especially over time. The frame of the first adhesive material reinforces the photovoltaic module, such that it can be handled easily. In particular, the first and the second flexible substrates are firmly attached to each other along the frame of the first adhesive material during and after singularization.

### BRIEF DESCRIPTION OF THE DRAWINGS

Embodiments of the invention will now be described by way of example with reference to the accompanying drawings, of which:
Figs. 1a-1c show a top view of a photovoltaic sheet with photovoltaic modules in accordance with the present invention;
Figs. 2a-2d show a photovoltaic module of the present invention;
Fig. 3 shows a top view of the photovoltaic sheet of the present invention;
Figs. 4a and 4b show a cross-sectional view along line a-a of the photovoltaic sheet depicted in Fig. 3;
Fig. 5 shows a cross-sectional view along line b-b of the photovoltaic sheet depicted in Fig. 3;
Figs. 6 and 7 show a cross-sectional view along line b-b of the photovoltaic sheet depicted in Fig. 3 according to other embodiments;
Figs. 8a-8b depict a top view of the photovoltaic modules comprising a U- or V-shaped portion, i.e. the busbar comprises an elongated portion. Fig 8c shows a schematic cross-section taken along b-b of the photovoltaic module illustrated in Fig 8b after a second substrate has been put on top;
Fig. 9 shows a photovoltaic module of the present invention;
Fig. 10 depict the method for manufacturing the photovoltaic sheet according to the invention.

### DETAILED DESCRIPTION OF THE INVENTION

In the present detailed description, embodiments of the present invention will be discussed with the accompanying figures. It should be noted that this by no means limits the scope of the invention, which is also applicable in other circumstances for instance with other types or variants of methods for laminating a photovoltaic module or other types or variants of photovoltaic module than the embodiments shown in the appended drawings. Further, that specific features are mentioned in connection to an embodiment of the invention does not mean that those components cannot be used to an advantage together with other embodiments of the invention.

The following description will use terms such as "top", "bottom", "outer" etc. These terms generally refer to the views and orientations as shown in the drawings. The terms are used for the reader's convenience only and shall not be limiting.

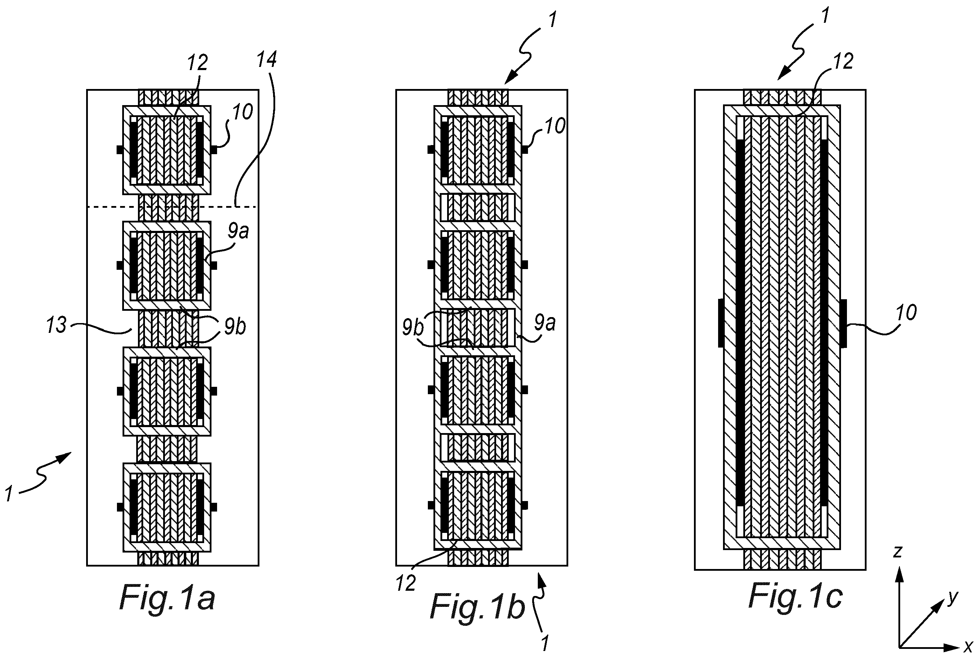

Fig. 1a shows a photovoltaic sheet 1 according to the present invention. The photovoltaic sheet 1 comprises four photovoltaic modules 12. The outer and intermediate electrodes of each photovoltaic module 12 is framed individually by the longitudinal portions 9a and the transverse portions 9b of the frame of the first adhesive material 9. The transverse portions 9b of the first adhesive material between two adjacent photovoltaic modules 12 are separated by gaps 13 wherein a cutting line 14 may be arranged. Photovoltaic modules according to the embodiment shown in Fig. 1a have the advantage of good adhesive properties along the entire periphery.

Further, as shown in Fig. 1b, the photovoltaic sheet 1 comprise a plurality of photovoltaic modules 12, where the outer and intermediate electrodes of each photovoltaic module 12 is framed by the frame 9 of the first adhesive material, wherein the frames comprise at least one common portion. After separation along e.g. a cutting line, the photovoltaic sheet 1 may comprise a single photovoltaic module 12 extending throughout the entire photovoltaic sheet 1 as shown in Fig. 1c. Each of the photovoltaic modules 12 in Figs. 1a-1c comprise a pair of connectors or busbars 10.

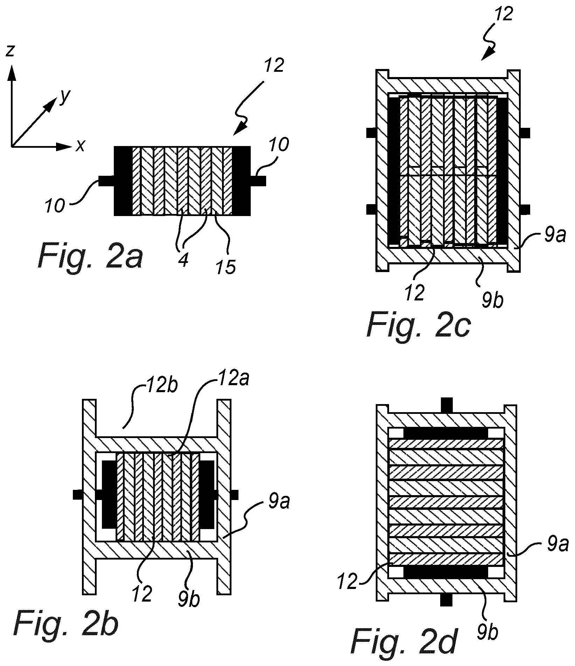

Fig. 2a schematically shows a top view of a photovoltaic module 12, comprising a plurality of first electrode stripes 4 arranged on a first substrate (not shown). The photovoltaic module further comprises a plurality of second electrode stripes (not shown) being arranged on a second substrate (not shown). The electrodes in both the plurality of first electrodes 4 and in the plurality of second electrodes 5 are separated from each other by gaps 15, . Moreover, the electrodes 4 are sandwiched between the first and second substrates and an active layer (not shown) is sandwiched between the plurality of first and second electrodes. Additionally, the photovoltaic module 12 comprises a pair of connectors or busbars 10 for extracting the generated energy.

Fig. 2b illustrates one example of a photovoltaic module 12, wherein the a portion of each one of the plurality of first and second continuous electrodes are framed by the frame 9 of the first adhesive material. The frame 9 of the first adhesive material 9 divides the photovoltaic module in an inner part 12a and an outer part 12b. As may be seen in Fig. 2b, a portion of each connector or busbar extends outside the frame 9 of the first adhesive material.

In a different example shown in Fig. 2c, a photovoltaic module 12 comprises two pairs of connectors or busbars 10.

In an embodiment depicted in Fig. 2d, a photovoltaic module 12 comprises a first and a second substrate portion longest extension of which being perpendicular to the longest extension of the plurality of first and second electrodes 4, 5, i.e. to z-direction.

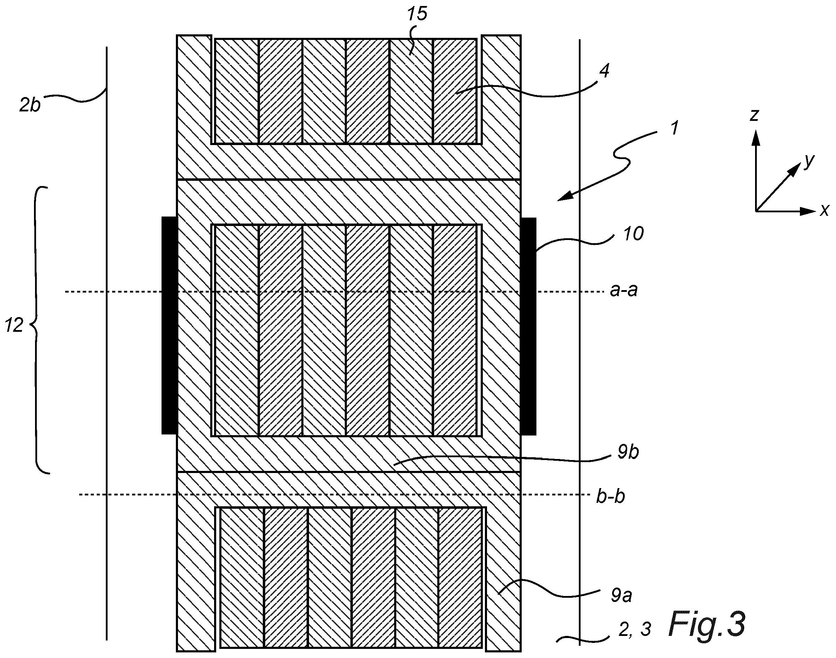

The intrinsic structure of the photovoltaic sheet 1 will now be described in greater detail below. Fig. 3 represents a top view of the photovoltaic sheet 1 according to the present invention. The photovoltaic sheet 1 according to the present invention comprises a first and a second flexible substrate 2, 3 having a longitudinal extension in z-direction and a transverse extension in x-direction being perpendicular to the z-direction. The first and the second flexible substrates 2, 3 are superimposed.

The photovoltaic sheet 1 shown in Fig. 3 further comprises a first lateral portion 2a and a second lateral portion 2b, wherein the first and the second lateral portions 2a, 2b extends in the z-direction and are spaced apart in the x-direction, and are preferably arranged outside said photovoltaic modules and optionally at a respective edge of said substrate. The photovoltaic sheet 1 further comprises a plurality of photovoltaic modules 12.

The photovoltaic sheet 1 further comprises a plurality of first electrodes 4 arranged in physical contact with the first substrate and extending in z-direction.

The photovoltaic sheet 1 shown in Fig. 3 further comprises a continuous frame of the first non-conductive adhesive material comprising two continuous longitudinal portions 9a of a first adhesive material arranged at the first and the second lateral portion 2a, 2b, respectively, and extending in z-direction. Further, the photovoltaic sheet 1 comprises two continuous transverse portions 9b of the first adhesive material extending in the x-direction, the transverse portions 9b of the first adhesive material are spaced apart in the z-direction. The longitudinal portions 9a and the transverse portions 9b of the first adhesive material encircle a portion of each one of the plurality of first and second continuous electrodes in the photovoltaic module 12. The longitudinal portions 9a and the transverse portions 9b are arranged between the respective plurality of the continuous first and second electrodes 4, 5. In other words, the longitudinal portions 9a and the transverse portions 9b are arranged between the plurality of continuous first electrodes 4 and the plurality of continuous second electrodes 5. In this example embodiment, the frame of the first adhesive material is rectangular.

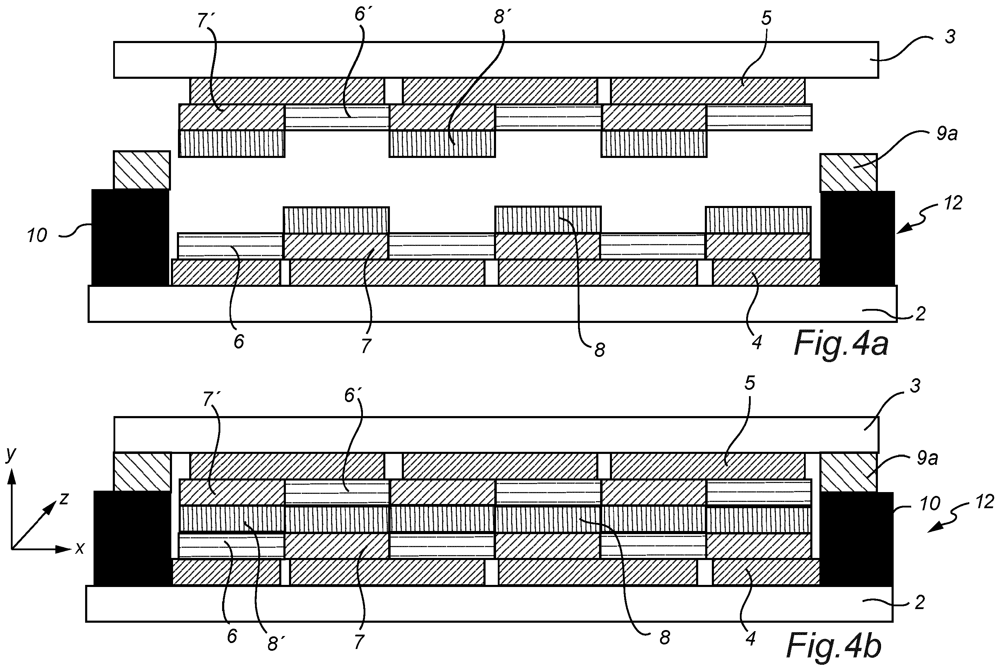

Figs. 4a and 4b show the cross-section of the photovoltaic sheet 1 depicted in Fig. 3 across line a-a, i.e. across the photovoltaic module 12. As may be seen in Fig. 4a, the photovoltaic sheet 1 is shown prior to lamination of the first substrate 2 and the second substrate 3 together, while Fig. 4b shows the photovoltaic sheet after the lamination step has been completed.

The first substrate 2 comprises a plurality of first electrodes 4, extending in z-direction and separated in x-direction by gaps 15. Alternating portions of hole transport layer (HTL) 6 and electron transport layer (ETL) 7 are arranged on the plurality of first electrodes 4. Further, portions of active layer 8 are arranged on the HTL/ETL layer. A connector 10 or busbar 10 is arranged on each of the first and the second lateral portions 2a, 2b. On top of each busbar 10 a longitudinal portion 9a of the first adhesive material is arranged. After lamination both connectors 10 or busbars 10 are in electronic contact with a respective outer electrode of said plurality of first electrodes 4.

The second substrate 3 comprises a plurality of second electrodes 5, extending in z-direction and separated in x-direction by gaps 15. Alternating portions of hole transport layer (HTL) 6' and electron transport layer (ETL) 7' are arranged on the plurality of second electrodes 5. It should be noted that when the first and the second substrates 2, 3 are superimposed, the ETL portion 7 on the first substrate 2 should be positioned in association with an HTL portion 6' on the second substrate 3, and vice versa. Portions of active layer 8' are arranged on the HTL/ETL layer of the second substrate 3 such that the active layer portions 8, 8' are not superimposed when the first and the second substrates 2, 3 are superimposed, as shown in Fig. 4b.

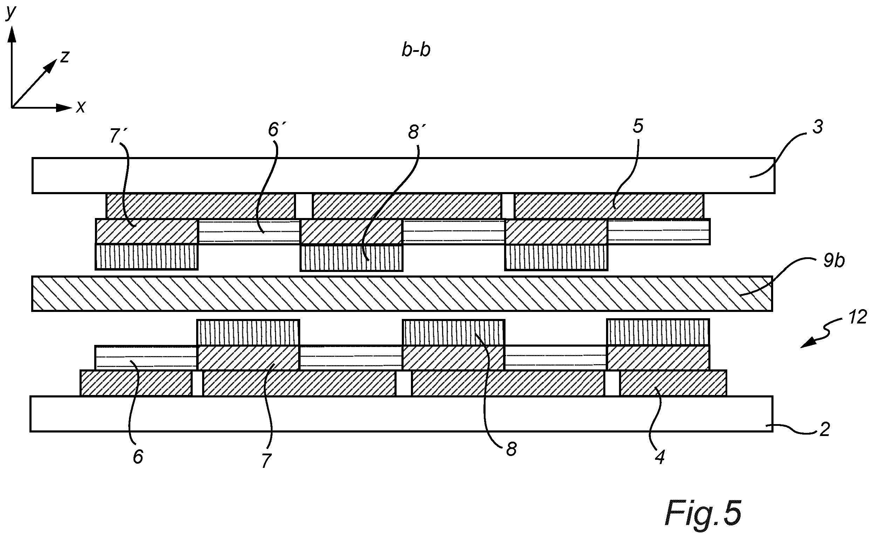

Fig. 5 depicts the cross-section of the photovoltaic sheet 1 depicted in Fig. 3 across line b-b, i.e. across the transverse portion 9b of the frame 9 of the first adhesive material. As may be seen in Fig. 5, the photovoltaic sheet 1 is shown prior to lamination of the first substrate 2 and the second substrate 3 together. In Fig 5 it may also be seen that the transverse portion 9b is arranged between the respective plurality of the continuous first and second electrodes 4, 5. In other words, the transverse portion 9b is arranged between the plurality of continuous first electrodes 4 and the plurality of continuous second electrodes 5. The layers of the photovoltaic module 12 are the same as described in relation to Figs. 4a and 4b. When the first and the second substrates 2, 3 are laminated, the transverse portion 9b of the frame 9 of the first adhesive material will be arranged between the active layer portions 8, 8', such that there is no electrical contact between the plurality of first and second electrodes along the frame of the first adhesive material.

Fig 4 and 5 show that the continuous frame of adhesive material (9a, 9b) is arranged between a respective portion of each continuous first electrode 4 and a respective portion of each continuous second electrode 5.

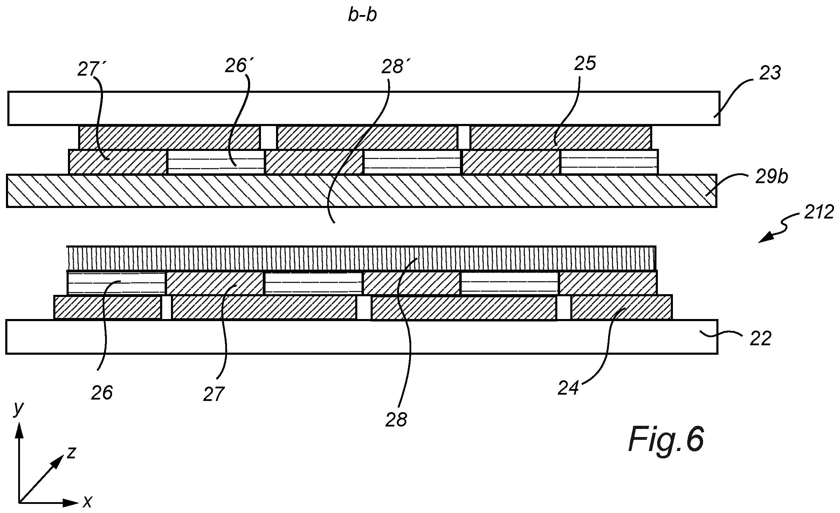

In the embodiment shown in Fig. 6, the transverse portion 29b of the frame 29 of the first adhesive material is arranged at the ETL/HTL layer 26', 27'. When the first substrate 22 and the second substrate 23 are laminated, the transverse portion 29b of the frame 29 of the first adhesive material will be arranged between the active layer 28 and the ETL/HTL layer 26', 27'. It should be noted that it is possible to arrange the transverse portion 29b of the first adhesive material on the ETL/HTL layer 26, 27 associated with the first substrate 22.

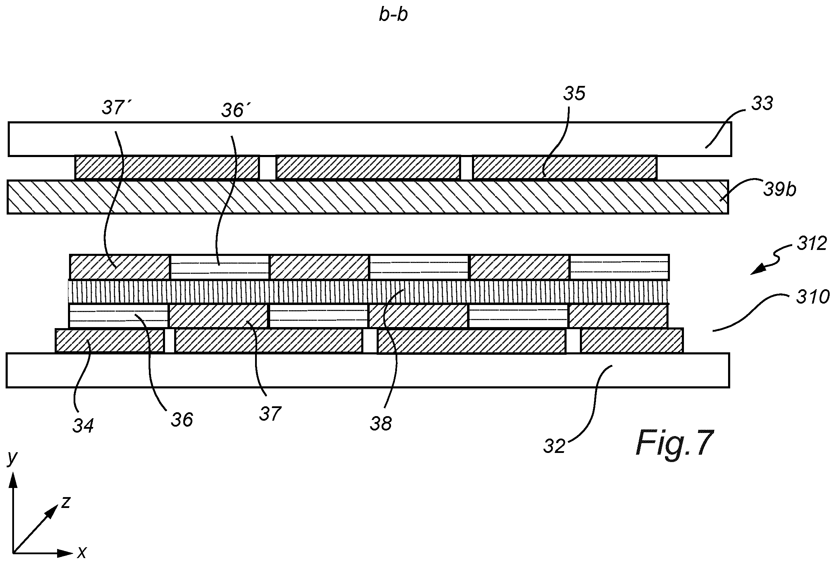

Another example is illustrated in Fig. 7, wherein the transverse portion 39b of the frame 39 of the first adhesive material is arranged between the plurality of the second electrodes 35 and the ETL/HTL layer 36', 37'. It should be noted that it is possible to arrange the transverse portion 39b of the frame 39 of the first adhesive material on the plurality of first electrodes 34, or to arrange two transverse portions of the first adhesive material on both the plurality of first and second electrodes 34, 35. According to the embodiment depicted in Fig. 7, the electrodes are thus arranged in W-configuration. It is also feasible to arrange the electrodes in Z-configuration, e.g. as described in WO2020/038937, which in incorporated herein by reference.

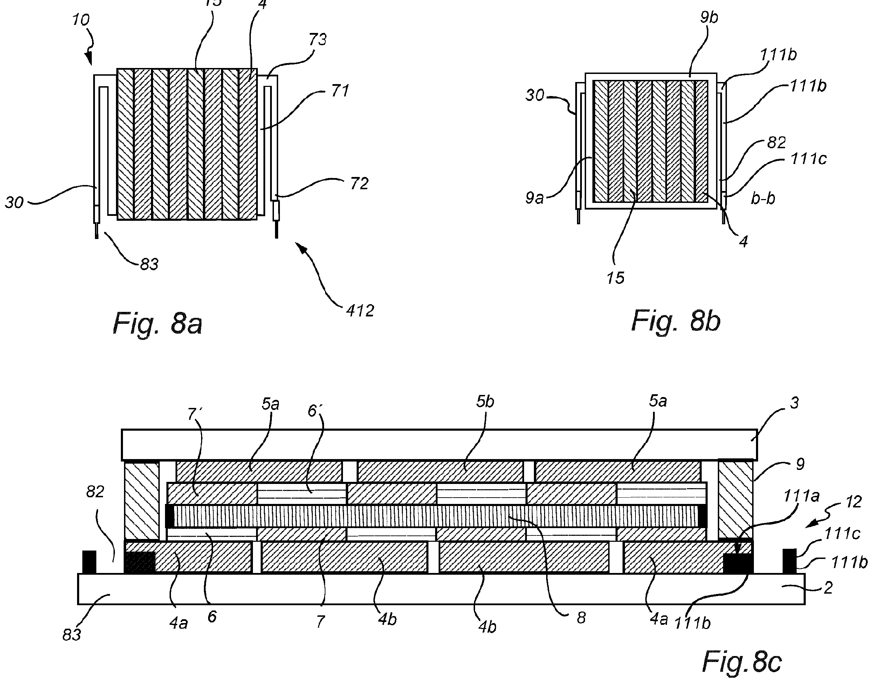

In Fig. 8a, an intermediate photovoltaic module 412 is shown, comprising a first substrate (not shown) and a plurality of continuous first electrodes as well as a hole transport layer 6, and an electron transport layer 7 ; wherein each of the busbars comprise a contact bridge 30 as described above. In Fig. 8b, the frame 9 of the first adhesive material has been applied such that the photovoltaic module 12 is framed by the frame 9, and the contact bridges 30 of the busbars 10 are extending outside the frame 9. Fig. 8c shows a cross-section of the photovoltaic module when an active layer 8, and a second substrate comprising a pluralty of second electrodes, 5a, 5b, hole transport layer 6', electron transport layer 7' and active layer 8 has been provided on top of the device shown in Fig 8b. Said plurality of first and second continuous electrodes comprises four outmost electrodes 4a, 5a an three intermediate electrodes 4b,5b (shown in figure 8c).

According to one example, said pair of connectors 10 comprises a first and second electronically conductive connector. Each one of said first and second connectors comprises a first terminal portion 111a in physical contact with one of said outmost electrodes 4a, a second terminal portion 111c (shown in fig 8c) and an intermediate portion 111b arranged between said first and second terminal portions 111a, 111b. The intermediate portion 111c of said first and second electronically conductive connector is arranged between, and optionally at least partially in direct contact with, one of said first and second flexible substrates and a portion of said continuous frame of adhesive material. The second terminal portion 111c of said first and second electrically conductive connector is preferably arranged outside said continuous frame of said first adhesive material 9b and optionally exposed so as to enable for connection of the photovoltaic module to other photovoltaic modules or a load.

According to at least one embodiment such as the one shown in Figs. 8a-c, said first terminal portion 111a is elongated and extends in said z-direction, and both said first and second electrically conductive connectors comprises a substantially U- or V-shaped portion 71,72,73 which substantially U- or V-shaped portion partly encircles an elongated portion or elongated area 82 arranged to the side of said plurality of first and second continuous electrodes. In Fig 8a the U-shaped portion 71, 72,73 encircles a void o. When the first and second substrates have been laminated to each other the substantially U- or V-shaped portion may e.g. encircle a void or an adhesive adhering two substrates to each other. The substantially U- or V-shaped portion comprises two elongated portions 71,72 joined by a linking portion 73, wherein one of said elongated portions 71 coincides with said first terminal portion and the other elongated portion 72 preferably extends in a direction substantially parallel with said first elongated portion 71. According to one example said elongated portions are separated by a distance within the range of 0.1 - 50 mm in the x-direction. According to one example, said elongated portions are separated by a distance of at least 0.1 mm, or at least 0.5 mm, or at least 1 mm, or at least 3 mm, or at least 5 mm. Additionally or alternatively, said elongated portions are separated by a distance of at most 50 mm, or at most 20 mm, or at most 10 mm, or at most 3 mm.The linking portion 73 may be straight or curved. One or both of the elongated portions 71, 72 are preferably straight or substantially straight. According to one example, the other of said elongated portions 72 extends in a direction which deviates from said z-direction by α degrees, where α is in the rage of 0 to 20 degrees and preferably within the range of 0 to 10.

After lamination at least a portion of said second terminal portion 111c is optionally exposed to ambient so as to enable connection further circuits or loads.

The partly encircled elongated portion 82 arranged to the side of said first and second plurality of continuous electrodes may be fully or partly removed or disrupted, e.g. by cutting, to increase the separation between the second terminal portion and the photovoltaic module by extending the shortest continuous path (between the substrates) from the second terminal portion 111c to the outmost electrode 4a, 5a, which shortest continuous path runs between the substrates. The disruption may be achieved by cutting along a line 83 which is e.g. entered between the two elongated portions 72,73.

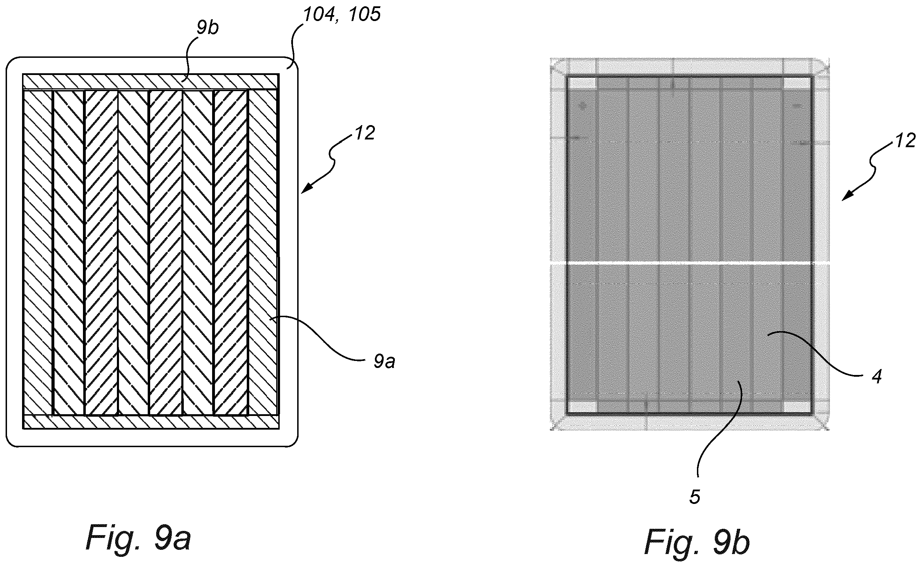

Fig. 9 shows a photovoltaic module 12 of the present invention, wherein the photovoltaic module has been provided with a barrier substrate 104, 105.

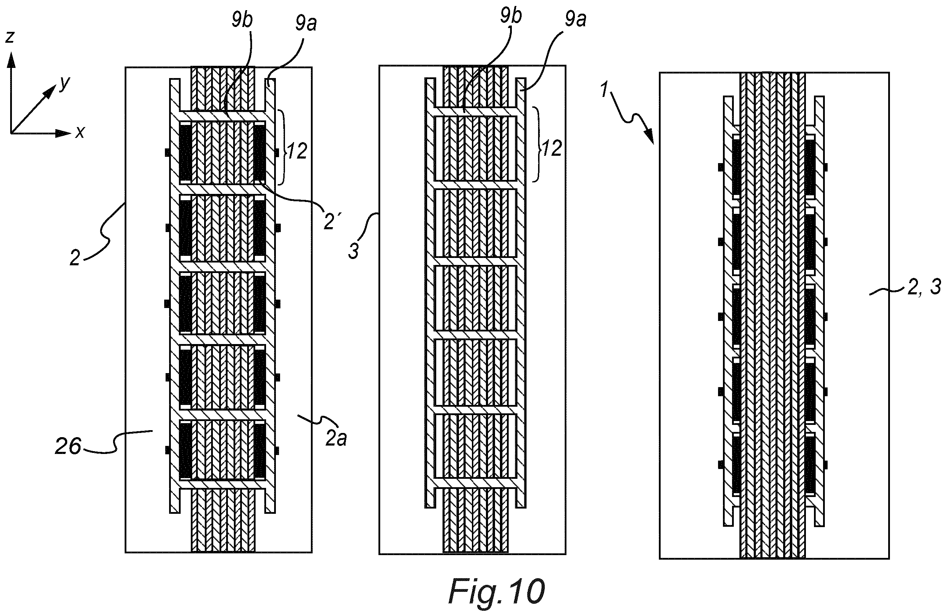

Fig. 10 shows one example of forming the photovoltaic sheet 1, wherein the first and the second substrates 2, 3 with the respective plurality of electrodes 4, 5 are shown. The frame 9 of the first adhesive material is applied on the first substrate 2 comprising continuous longitudinal portions 9a extending in z direction and further with intersecting continuous transverse portions 9b extending in the x-direction. In more detail, the intersecting longitudinal and transverse portions frame a portion of the photovoltaic modules 12 and create a ladder-like appearance. By laminating the substrates 2, 3 together while aligning the adhesive portions 9a, 9b on the respective substrates, the completed photovoltaic sheet 1 is achieved.

The longitudinal portions of adhesive material (i.e. the portions of adhesive material extending in the z-direction) may be applied close to or even partially on top of the photovoltaic module, e.g. within 10 nm to 1 mm from the photovoltaic module, since minimization of gaps at the inner surface may facilitate the reduction of air pockets in the finished product. The transverse portion of adhesive material (i.e. the portions of adhesive material extending in said xz-plane in a direction transvers to the z-direction) in the laminated photovoltaic sheet preferably extends across each one of said plurality of first and second electrodes.)

In the embodiment shown e.g. in Fig. 10 and Fig. 3 the photovoltaic sheet comprises a plurality of frames, wherein each two adjacent frames have a common portion. In particular, a respective transverse portion of two adjacent frames of the plurality of frames is formed of a continuous layer of adhesive material and/or at least partly coincide.

In the embodiment shown in Fig 10 describing a method of producing a photovoltaic sheet, the at least one continuous frame of said first adhesive material is a plurality of frames; wherein each one of said plurality of frames a respective one of said at least one photovoltaic modules, and said plurality of frames together frames a plurality of photovoltaic modules. The photovoltaic sheet may be configured to be cut along at least one cutting line in x-z plane to separate at least one of said photovoltaic modules from the other photovoltaic modules of said plurality of photovoltaic modules. In the embodiment shown in Fig 10 the cutting line may be arranged within a transverse portion of frame, which transverse portion extends across each one of said plurality of electrodes.

Although the present invention has been described with reference to various embodiments, those skilled in the art will recognize that changes may be made without departing from the scope of the invention. It is intended that the detailed description be regarded as illustrative and that the appended claims are intended to define the scope of the invention.

## Claims

1. A photovoltaic sheet (1) comprising a first and a second flexible substrate (2, 3), wherein said first and said second flexible substrates (2, 3) are at least partially superimposed,
wherein said photovoltaic sheet (1) further comprises:
a plurality of continuous first electrodes (4) arranged in physical contact with said first substrate (2), wherein each of said first electrodes (4) has a longitudinal extension in substantially z-direction, and wherein said plurality of first electrodes (4) are spaced in substantially x-direction being perpendicular to said z-direction and in the x-direction substantially centered around a first center line directed in said z-direction, wherein said plurality of continuous first electrodes consists of a first pair of outmost electrodes,
a plurality of continuous second electrodes (5) arranged in physical contact with said second substrate (3), wherein each of said second electrodes (5) has a longitudinal extension in said z-direction, and wherein said plurality of second electrodes (5) is spaced in substantially x-direction being perpendicular to said z-direction and in the x-direction substantially centered around a second center line directed in said z-direction, wherein said plurality of continuous second electrodes comprises a second pair of outmost electrodes; wherein said plurality of said first and said second electrodes (4, 5) is arranged between said first and second substrates (2, 3);
at least one active layer (8) arranged between said plurality of first electrodes (4) and said plurality of second electrodes (5);
a set of outmost electrodes consisting of said first pair of outmost electrodes and said second pair of outmost electrodes,
wherein said photovoltaic sheet (1) further comprises at least two photovoltaic modules, each photovoltaic module comprising:
- a pair of connectors comprising a first and a second electronically conductive connector, wherein a first terminal portion of said first electrically conductive connector is arranged in physical contact with a first outmost electrode in said set of outmost electrodes, and a first terminal portion of said second electrically conductive connector is in physical contact with a second outmost electrode in said set of outmost electrodes, said first and second outmost electrodes being arranged on opposite sides of a plane coinciding with said first and second center lines,
**characterized by**
- a continuous frame (9a, 9b) of a first non-conductive adhesive material arranged between said respective plurality of continuous first and second electrodes and arranged between said first and said second substrate (2, 3) adhering the first and second substrates (2, 3) to each other and which frame extends across at least a portion of each electrode of said plurality of first electrodes and across at least a portion of each electrode in said plurality of second electrodes and, frames a respective portion of said first plurality of first electrodes and a respective portion of said plurality of second electrodes.

2. The photovoltaic sheet (1) according to claim 1, wherein each one of said first and second electronically conductive connectors further comprises a second terminal portion and an intermediate portion arranged between said first and second terminal portions, wherein for each pair of connectors said intermediate portion of said first and second electronically conductive connector is arranged between one of said first and second flexible substrates and a portion of said continuous frame of adhesive material, and said second terminal portion of said first and second electrically conductive connector is preferably arranged outside said continuous frame of said first adhesive material. (4, 5).

3. The photovoltaic sheet (1) according to claim 2, wherein said first terminal portion is elongated and extends in said z-direction, each one of said first and second electrically conductive connectors comprises a substantially U- or V-shaped portion which substantially U- or V-shaped portion partly encircles an elongated portion arranged to the side of said plurality of first and second continuous electrodes, wherein said substantially U- or V-shaped portion comprises two elongated portions, wherein one of said elongated portion coincides with said first terminal portion and the other preferably extends in a direction substantially parallel with said first elongated portion.

4. The photovoltaic sheet (1) according to any one of the preceding claims, wherein a respective portion (9b) of two adjacent frames of said at least two frames is formed of a continuous layer of adhesive material and/or at least partly coincide.

5. The photovoltaic sheet (1) according to any one of the preceding claims, wherein said first non-conductive adhesive material is a pressure-sensitive adhesive (PSA), preferably selected from a group consisting of acrylate polymers, natural rubber, synthetic thermoplastic elastomer and silicone rubber.

6. The photovoltaic sheet (1) according to any one of the preceding claims, wherein the thickness of each of said at least two frames in a direction perpendicular to said first and second substrates is within a range of 10 nm to 50 µm.

7. The photovoltaic sheet (1) according to any one of the preceding claims, wherein each one of said at least two frames is formed of one or more lines each having a respective direction of extension, wherein the width of each line is within a range of 10 µm to 100 mm in a direction parallel with said substrate and transverse to the direction of extension of said line.

8. The photovoltaic sheet (1) according to any one of the preceding claims, wherein said photovoltaic sheet (1) further comprises an electron transport layer (7) being arranged between said at least one active layer (8) and one of said plurality of first electrodes (4) and said plurality of second electrodes (5), and wherein each one of said at least two frames (9a, 9b) of said first non-conductive adhesive material comprises at least one portion being arranged between said electron transport layer (7) and said at least one active layer (8).

9. The photovoltaic sheet (1) according to any one of the preceding claims, wherein said photovoltaic sheet (1) further comprises a hole transport layer (6) being arranged between said at least one active layer (8) and one of said plurality of first electrodes (4) and/or said plurality of second electrodes (5), and wherein each one of said at least two frames (9a, 9b) of said first non-conductive adhesive material comprises at least one portion being arranged between said hole transport layer (6) and said at least one active layer (8).

10. The photovoltaic sheet (1) according to any one of the preceding claims, wherein each one of said at least two frames (9a, 9b) of said first non-conductive adhesive material frames one respective photovoltaic module (12), and wherein said photovoltaic sheet (1) is configured to be cut along at least one cutting line in x-z plane to separate at least one of said photovoltaic modules (12) from the other photovoltaic modules of said plurality of photovoltaic modules, wherein said cutting line preferably coincides with at least a portion of said frame of said adhesive material.

11. A photovoltaic module (12) comprising a first substrate portion of a first flexible substrate (2) and a second substrate portion of a second flexible substrate (3), wherein said first and said second substrate portions are at least partially superimposed,
wherein said photovoltaic module further comprises:
a plurality of first electrodes (4) arranged in physical contact with said first substrate portion, wherein each of said first electrodes (4) has a longitudinal extension in substantially z-direction, and wherein said plurality of first electrodes (4) are spaced in substantially x-direction being perpendicular to said z-direction, and substantially centered around a first center line directed in said z-direction, wherein said plurality of continuous first electrodes comprises a first pair of outmost electrodes,
a plurality of second electrodes (5) arranged in physical contact with said second substrate portion, wherein each of said second electrodes (5) has a longitudinal extension in said z-direction, and wherein said plurality of second electrodes (5) is spaced in substantially x-direction being perpendicular to said z-direction, and substantially centered around a second center line directed in said z-direction, wherein said plurality of continuous second electrodes comprises a second pair of outmost electrodes, wherein said plurality of said first and said second electrodes (4, 5) are arranged between said first and second substrate portions,
a set of outmost electrodes consisting of said first pair of outmost electrodes and said second pair of outmost electrodes,
a pair of connectors comprising a first and a second electronically conductive connector, wherein a first terminal portion of said first electrically conductive connector is arranged in direct contact with a first outmost electrode in said set of outmost electrodes, and a first terminal portion of said second electrically conductive connector is in direct contact with a second outmost electrode in said set of outmost electrodes, said first and second outmost electrodes being arranged on opposite sides of a plane coinciding with said first and second center lines,
at least one active layer (8) arranged between said plurality of first electrodes (4) and said plurality of second electrodes (5);
**characterized by**
said photovoltaic module (12) further comprises at least one continuous frame of a first non-conductive adhesive material arranged between said first and said second substrate portions adhering the first and second substrates (2, 3) to each other, extends across at least a portion of each electrode of said plurality of first electrodes and across at least a portion of each electrode in said plurality of second electrodes, and wherein said at least one frame of said first adhesive material frames a respective portion of said plurality of first electrodes (4) and frames a respective portion of said plurality of second electrodes (5).

12. A method for producing a photovoltaic sheet (1), said method comprising the steps of:
a) providing a first flexible substrate (2) and a second flexible substrate (3);
b) providing a plurality of first continuous electrodes (4) on said first flexible substrate (2) and a plurality of second continuous electrodes directly(5) on said second flexible substrate (3); said first and said second continuous electrodes (4, 5) extending in z-direction and being spaced in x-direction being perpendicular to said z-direction;
c) providing at least two pair of connectors, each pair of connectors comprising a first and a second electronically conductive connector, and arranging each first electronically conductive connector in physical contact with a first outermost electrode of said plurality of first and second electrodes, and each second electronically conductive connector is in physical contact with a second outermost electrode of said plurality of first and second electrodes;
d) providing at least one active layer (8) on said plurality of first electrodes (4) and/or said plurality of second electrodes (5);
e) providing at least two continuous or discontinuous frames of a first non-conductive adhesive material on said first and/or said second substrate (2, 3), such that each one of said at least two frames of said first adhesive material frames a respective portion of said first plurality of first electrodes (4)
f) laminating by means of heat and/or pressure said first and said second substrate (2, 3) together such that said first adhesive material adheres the first and second substrates (2, 3) to each other to form said photovoltaic sheet (1);
**characterized in that** said plurality of first and second electrodes (4, 5) are arranged between said first and second substrates (2, 3); such that said at least one active layer (8) is arranged between and in electrical contact with said plurality of first electrodes (4) and said plurality of second electrodes (5), and such that each one of said at least two frames of said first adhesive material is continuous and extends across at least a portion of each electrode of said plurality of first electrodes, across at least a portion of each electrode in said plurality of second electrodes, and across a respective pair of said at least two pair of connectors, and wherein after lamination said at least one frame of said first adhesive material frames a respective portion of said first plurality of first electrodes and a respective portion of said plurality of second electrodes (12).

13. The method according to claim 12, wherein step e) occurs before step d).

14. The method according to claim 12 or 13, wherein step e) comprises forming a respective portion of said adhesive material of two adjacent frames by a continuous layer of said first non-conductive adhesive material.

15. The method according to any one of claims 12-14, further comprising the step of:
g) after said lamination cutting said photovoltaic sheet (1) along at least one cutting line extending in x-z plane to separate at least one of said photovoltaic modules (12) from said plurality of photovoltaic modules; wherein said cutting line preferably coincides with at least a portion of said frame of said first adhesive material.

16. The method according to claim 14, wherein said method further comprises the steps of:
h) providing a first and a second barrier substrate (104, 105);
i) providing a second adhesive material on said first and/or said second barrier substrate (104, 105);
j) arranging at least one of said photovoltaic modules (12) on said first or said second barrier substrate (104, 105);
k) laminating said first and said second barrier substrates (104, 105) together such that said at least one photovoltaic module (12) is arranged between said first and said second barrier substrate (104, 105).

17. The method according to any one of claims 12-16, wherein said method of providing at least two pair of connectors further comprises the steps of providing each one of said first and second electrically conductive connectors with a substantially U- or V-shaped portion, which substantially U- or V-shaped portion partly encircles an elongated portion arranged to the side of said plurality of first and second continuous electrodes, wherein said substantially U- or V-shaped portion comprises two elongated portions, wherein one of said elongated portions coincides with said first terminal portion and the other preferably extends in a direction substantially parallel with said first elongated portion.

## Patentansprüche

1. Photovoltaische Folie (1), die ein erstes und ein zweites flexibles Substrat (2, 3) umfasst, wobei das erste und das zweite flexible Substrat (2, 3) zumindest teilweise überlagert sind,
wobei die photovoltaische Folie (1) ferner umfasst:
mehrere durchgehende erste Elektroden (4), die in physischem Kontakt mit dem ersten Substrat (2) angeordnet sind, wobei jede der ersten Elektroden (4) eine Längserstreckung in im Wesentlichen z-Richtung aufweist und wobei die mehreren ersten Elektroden (4) in im Wesentlichen x-Richtung, die senkrecht zur z-Richtung ist, beabstandet sind und in der x-Richtung im Wesentlichen um eine erste Mittellinie, die in der z-Richtung verläuft, zentriert sind, wobei die mehreren durchgehenden ersten Elektroden aus einem ersten Paar äußerster Elektroden bestehen,
mehrere durchgehende zweite Elektroden (5), die in physischem Kontakt mit dem zweiten Substrat (3) angeordnet sind, wobei jede der zweiten Elektroden (5) eine Längserstreckung in der z-Richtung aufweist und wobei die mehreren zweiten Elektroden (5) in im Wesentlichen x-Richtung, die senkrecht zur z-Richtung ist, beabstandet sind und in der x-Richtung im Wesentlichen um eine zweite Mittellinie, die in der z-Richtung verläuft, zentriert sind, wobei die mehreren durchgehenden zweiten Elektroden ein zweites Paar äußerster Elektroden umfassen; wobei die mehreren der ersten und der zweiten Elektroden (4, 5) zwischen dem ersten und dem zweiten Substrat (2, 3) angeordnet sind;
mindestens eine aktive Schicht (8), die zwischen den mehreren ersten Elektroden (4) und den mehreren zweiten Elektroden (5) angeordnet ist;
einen Satz äußerster Elektroden, der aus dem ersten Paar äußerster Elektroden und dem zweiten Paar äußerster Elektroden besteht,
wobei die photovoltaische Folie (1) ferner mindestens zwei photovoltaische Module umfasst, wobei jedes photovoltaische Modul umfasst:
- ein Paar von Verbindern, das einen ersten und einen zweiten elektronisch leitfähigen Verbinder umfasst, wobei ein erster Anschlussteil des ersten elektrisch leitfähigen Verbinders in physischem Kontakt mit einer ersten äußersten Elektrode in dem Satz von äußersten Elektroden angeordnet ist und ein erster Anschlussteil des zweiten elektrisch leitfähigen Verbinders in physischem Kontakt mit einer zweiten äußersten Elektrode in dem Satz von äußersten Elektroden ist, wobei die erste und die zweite äußerste Elektrode auf gegenüberliegenden Seiten einer Ebene angeordnet sind, die mit der ersten und der zweiten Mittellinie zusammenfällt, **gekennzeichnet durch**
- einen durchgehenden Rahmen (9a, 9b) aus einem ersten nicht leitenden Klebematerial, der zwischen den jeweiligen mehreren durchgehenden ersten und zweiten Elektroden angeordnet ist und zwischen dem ersten und dem zweiten Substrat (2, 3) angeordnet ist und das erste und das zweite Substrat (2, 3) miteinander verklebt und der sich über mindestens einen Teil jeder Elektrode der mehreren ersten Elektroden und über mindestens einen Teil jeder Elektrode der mehreren zweiten Elektroden erstreckt, einen jeweiligen Teil der ersten mehreren ersten Elektroden und eines jeweiligen Teils der mehreren zweiten Elektroden umrahmt.

2. Photovoltaische Folie (1) nach Anspruch 1, wobei sowohl der erste als auch der zweite elektronische leitfähige Verbinder ferner einen zweiten Anschlussteil und einen Zwischenteil, der zwischen dem ersten und dem zweiten Anschlussteil angeordnet ist, umfasst, wobei für jedes Paar von Verbindern der Zwischenteil des ersten und des zweiten elektronisch leitfähigen Verbinders zwischen einem von erstem und zweitem flexiblen Substrat und einem Teil des durchgehenden Rahmens aus Klebematerial angeordnet ist und der zweite Anschlussteil des ersten und des zweiten elektrisch leitfähigen Verbinders vorzugsweise außerhalb des durchgehenden Rahmens aus dem ersten Klebematerial angeordnet ist (4, 5).

3. Photovoltaische Folie (1) nach Anspruch 2, wobei der erste Anschlussteil länglich ist und sich in der z-Richtung erstreckt, wobei sowohl der erste als auch der zweite elektrisch leitfähige Verbinder einen im Wesentlichen U- oder V-förmigen Teil umfasst, der im Wesentlichen U- oder V-förmige Teil teilweise einen länglichen Teil umschließt, der an der Seite der mehreren ersten und zweiten durchgehenden Elektroden angeordnet ist, wobei der im Wesentlichen U- oder V-förmige Teil zwei längliche Teile umfasst, wobei einer der länglichen Teile mit dem ersten Anschlussteil zusammenfällt und der andere sich vorzugsweise in einer Richtung im Wesentlichen parallel zu dem ersten länglichen Teil erstreckt.

4. Photovoltaische Folie (1) nach einem der vorhergehenden Ansprüche, wobei ein jeweiliger Teil (9b) von zwei benachbarten Rahmen der mindestens zwei Rahmen aus einer durchgehenden Schicht aus Klebematerial gebildet ist und/oder diese mindestens teilweise zusammenfallen.

5. Photovoltaische Folie (1) nach einem der vorhergehenden Ansprüche, wobei das erste nicht leitende Klebematerial ein Haftkleber (PSA, Pressure-Sensitive Adhesive) ist, vorzugsweise ausgewählt aus einer Gruppe bestehend aus Acrylatpolymeren, Naturkautschuk, synthetischem thermoplastischem Elastomer und Silikonkautschuk.

6. Photovoltaische Folie (1) nach einem der vorhergehenden Ansprüche, wobei die Dicke jedes der mindestens zwei Rahmen in einer Richtung senkrecht zum ersten und zweiten Substrat innerhalb eines Bereichs von 10 nm bis 50 µm liegt.

7. Photovoltaische Folie (1) nach einem der vorhergehenden Ansprüche, wobei jeder der mindestens zwei Rahmen aus einer oder mehreren Linien gebildet ist, die jeweils eine jeweilige Erstreckungsrichtung aufweisen, wobei die Breite jeder Linie innerhalb eines Bereichs von 10 µm bis 100 mm in einer Richtung parallel zum Substrat und quer zur Erstreckungsrichtung der Linie liegt.

8. Photovoltaische Folie (1) nach einem der vorhergehenden Ansprüche, wobei die photovoltaische Folie (1) ferner eine Elektronentransportschicht (7) umfasst, die zwischen der mindestens einen aktiven Schicht (8) und einer der mehreren ersten Elektroden (4) und der mehreren zweiten Elektroden (5) angeordnet ist, und wobei jeder der mindestens zwei Rahmen (9a, 9b) aus dem ersten nicht leitenden Klebematerial mindestens einen Teil umfasst, der zwischen der Elektronentransportschicht (7) und der mindestens einen aktiven Schicht (8) angeordnet ist.

9. Photovoltaische Folie (1) nach einem der vorhergehenden Ansprüche, wobei die photovoltaische Folie (1) ferner eine Lochtransportschicht (6) umfasst, die zwischen der mindestens einen aktiven Schicht (8) und einer der mehreren ersten Elektroden (4) und der mehreren zweiten Elektroden (5) angeordnet ist, und wobei jeder der mindestens zwei Rahmen (9a, 9b) aus dem ersten nicht leitenden Klebematerial mindestens einen Teil umfasst, der zwischen der Lochtransportschicht (6) und der mindestens einen aktiven Schicht (8) angeordnet ist.

10. Photovoltaische Folie (1) nach einem der vorhergehenden Ansprüche, wobei jeder der mindestens zwei Rahmen (9a, 9b) des ersten nicht leitenden Klebematerials ein jeweiliges photovoltaisches Modul (12) umrahmt und wobei die photovoltaische Folie (1) dazu ausgelegt ist, entlang mindestens einer Schnittlinie in x-z-Ebene geschnitten zu werden, um mindestens eines der photovoltaischen Module (12) von den anderen photovoltaischen Modulen der mehreren photovoltaischen Module zu trennen, wobei die Schnittlinie vorzugsweise mit mindestens einem Teil des Rahmens aus dem Klebematerial zusammenfällt.

11. Photovoltaisches Modul (12), das einen ersten Substratteil eines ersten flexiblen Substrats (2) und einen zweiten Substratteil eines zweiten flexiblen Substrats (3) umfasst, wobei der erste und der zweite Substratteil wenigstens teilweise überlagert sind, wobei das photovoltaische Modul ferner umfasst:
mehrere erste Elektroden (4), die in physischem Kontakt mit dem ersten Substratteil angeordnet sind, wobei jede der ersten Elektroden (4) eine Längserstreckung in im Wesentlichen z-Richtung aufweist und wobei die mehreren ersten Elektroden (4) in im Wesentlichen x-Richtung, die senkrecht zur z-Richtung ist, beabstandet sind und im Wesentlichen um eine erste Mittellinie, die in der z-Richtung verläuft, zentriert sind, wobei die mehreren durchgehenden ersten Elektroden ein erstes Paar äußerster Elektroden umfassen,
mehrere durchgehende zweite Elektroden (5), die in physischem Kontakt mit dem zweiten Substratteil angeordnet sind, wobei jede der zweiten Elektroden (5) eine Längserstreckung in der z-Richtung aufweist und wobei die mehreren zweiten Elektroden (5) in im Wesentlichen x-Richtung, die senkrecht zur z-Richtung ist, beabstandet sind und im Wesentlichen um eine zweite Mittellinie, die in der z-Richtung verläuft, zentriert sind, wobei die mehreren durchgehenden zweiten Elektroden ein zweites Paar äußerster Elektroden umfassen; wobei die mehreren der ersten und der zweiten Elektroden (4, 5) zwischen dem ersten und dem zweiten Substratteil angeordnet sind,
einen Satz äußerster Elektroden, der aus dem ersten Paar äußerster Elektroden und dem zweiten Paar äußerster Elektroden besteht,
ein Paar Verbinder, das einen ersten und einen zweiten elektronisch leitfähigen Verbinder umfasst, wobei ein erster Anschlussteil des ersten elektrisch leitfähigen Verbinders in direktem Kontakt mit einer ersten äußersten Elektrode in dem Satz von äußersten Elektroden angeordnet ist und ein erster Anschlussteil des zweiten elektrisch leitfähigen Verbinders in direktem Kontakt mit einer zweiten äußersten Elektrode in dem Satz von äußersten Elektroden ist, wobei die erste und die zweite äußerste Elektrode auf gegenüberliegenden Seiten einer Ebene angeordnet sind, die mit der ersten und der zweiten Mittellinie zusammenfällt,
mindestens eine aktive Schicht (8), die zwischen den mehreren ersten Elektroden (4) und den mehreren zweiten Elektroden (5) angeordnet ist;
**gekennzeichnet durch**
das photovoltaische Modul (12) ferner mindestens einen durchgehenden Rahmen aus einem ersten nicht leitenden Klebematerial umfasst, der zwischen dem ersten und dem zweiten Substratteil angeordnet ist, der das erste und das zweite Substrat (2, 3) miteinander verklebt und der sich über mindestens einen Teil jeder Elektrode der mehreren ersten Elektroden und über mindestens einen Teil jeder Elektrode der mehreren zweiten Elektroden erstreckt, und wobei der mindestens eine Rahmen aus dem ersten Klebematerial einen jeweiligen Teil der mehreren ersten Elektroden (4) umrahmt und einen jeweiligen Teil der mehreren zweiten Elektroden (5) umrahmt.

12. Verfahren zum Herstellen einer photovoltaischen Folie (1), wobei das Verfahren die Schritte umfasst:
a) Bereitstellen eines ersten flexiblen Substrats (2) und eines zweiten flexiblen Substrats (3);
b) Bereitstellen mehrerer erster durchgehender Elektroden (4) auf dem ersten flexiblen Substrat (2) und mehrerer zweiter durchgehender Elektroden direkt (5) auf dem zweiten flexiblen Substrat (3); wobei sich die erste und die zweite durchgehende Elektrode (4, 5) in z-Richtung erstrecken und in x-Richtung, die senkrecht zur z-Richtung ist, beabstandet sind;
c) Bereitstellen von mindestens zwei Paaren von Verbindern, wobei jedes Paar von Verbindern einen ersten und einen zweiten elektronisch leitfähigen Verbinder umfasst, und Anordnen jedes ersten elektronisch leitfähigen Verbinders in physischem Kontakt mit einer ersten äußersten Elektrode der mehreren ersten und zweiten Elektroden, und wobei jeder zweite elektronisch leitfähige Verbinder in physischem Kontakt mit einer zweiten äußersten Elektrode der mehreren ersten und zweiten Elektroden ist;
d) Bereitstellen mindestens einer aktiven Schicht (8) auf den mehreren ersten Elektroden (4) und/oder den mehreren zweiten Elektroden (5);
e) Bereitstellen von mindestens zwei durchgehenden oder nicht durchgehenden Rahmen aus einem ersten nicht leitfähigen Klebematerial auf dem ersten und/oder dem zweiten Substrat (2, 3), so dass jeder der mindestens zwei Rahmen aus dem ersten Klebematerial einen jeweiligen Teil der ersten mehreren ersten Elektroden (4) umrahmt,
f) Zusammenlaminieren des ersten und des zweiten Substrats (2, 3) mittels Wärme und/oder Druck, so dass das erste Klebematerial das erste und das zweite Substrat (2, 3) miteinander verklebt, um die photovoltaische Folie (1) zu bilden;
**dadurch gekennzeichnet, dass** die mehreren ersten und zweiten Elektroden (4, 5) zwischen dem ersten und dem zweiten Substrat (2, 3) angeordnet sind; so dass die mindestens eine aktive Schicht (8) zwischen und in elektrischem Kontakt mit den mehreren ersten Elektroden (4) und den mehreren zweiten Elektroden (5) angeordnet ist, und so, dass jeder der mindestens zwei Rahmen aus dem ersten Klebematerial durchgehend ist und sich über mindestens einen Teil jeder Elektrode der mehreren ersten Elektroden, über mindestens einen Teil jeder Elektrode der mehreren zweiten Elektroden und über ein jeweiliges Paar der mindestens zwei Paare von Verbindern erstreckt, und wobei nach dem Laminieren der mindestens eine Rahmen aus dem ersten Klebematerial einen jeweiligen Teil der ersten mehreren ersten Elektroden und einen jeweiligen Teil der mehreren zweiten Elektroden (12) umrahmt.

13. Verfahren nach Anspruch 12, wobei Schritt e) vor Schritt d) stattfindet.

14. Verfahren nach Anspruch 12 oder 13, wobei Schritt e) umfasst, einen jeweiligen Teil des Klebematerials von zwei benachbarten Rahmen durch eine durchgehende Schicht des ersten nicht leitenden Klebematerials zu bilden.

15. Verfahren nach einem der Ansprüche 12-14, ferner den Schritt umfassend:
g) nach dem Laminieren Schneiden der photovoltaischen Folie (1) entlang mindestens einer Schnittlinie, die sich in x-z-Ebene erstreckt, um mindestens eines der photovoltaischen Module (12) von den mehreren photovoltaischen Modulen zu trennen; wobei die Schnittlinie vorzugsweise mit mindestens einem Teil des Rahmens aus dem ersten Klebematerial zusammenfällt.

16. Verfahren nach Anspruch 14, wobei das Verfahren ferner die Schritte umfasst:
h) Bereitstellen eines ersten und eines zweiten Barrieresubstrats (104, 105);
i) Bereitstellen eines zweiten Klebematerials auf dem ersten und/oder dem zweiten Barrieresubstrat (104, 105);
j) Anordnen mindestens eines der photovoltaischen Module (12) auf dem ersten oder dem zweiten Barrieresubstrat (104, 105);
k) Zusammenlaminieren des ersten und des zweiten Barrieresubstrats (104, 105), so dass das mindestens eine photovoltaische Modul (12) zwischen dem ersten und dem zweiten Barrieresubstrat (104, 105) angeordnet ist.

17. Verfahren nach einem der Ansprüche 12-16, wobei das Verfahren zum Bereitstellen von mindestens zwei Paaren von Verbindern ferner die Schritte des Bereitstellens sowohl des ersten und als auch des zweiten elektrisch leitfähigen Verbinders mit einem im Wesentlichen U- oder V-förmigen Teil umfasst, wobei der im Wesentlichen U- oder V-förmige Teil teilweise einen länglichen Teil umschließt, der an der Seite der mehreren ersten und zweiten durchgehenden Elektroden angeordnet ist, wobei der im Wesentlichen U- oder V-förmige Teil zwei längliche Teile umfasst, wobei einer der länglichen Teile mit dem ersten Anschlussteil zusammenfällt und der andere sich vorzugsweise in einer Richtung im Wesentlichen parallel zu dem ersten länglichen Teil erstreckt.

## Revendications

1. Feuille photovoltaïque (1) comprenant un premier et un deuxième substrat souple (2, 3), lesdits premier et deuxième substrats souples (2, 3) étant au moins partiellement superposés,
ladite feuille photovoltaïque (1) comprenant en outre :
une pluralité de premières électrodes continues (4) disposées en contact physique avec ledit premier substrat (2), chacune desdites premières électrodes (4) ayant une extension longitudinale sensiblement dans la direction z, et les électrodes de ladite pluralité de premières électrodes (4) étant espacées sensiblement dans la direction x qui est perpendiculaire à ladite direction z et, dans la direction x, sensiblement centrées autour d'un premier axe dirigé dans ladite direction z, ladite pluralité de premières électrodes continues consistant en une première paire d'électrodes extérieures,
une pluralité de deuxièmes électrodes continues (5) disposées en contact physique avec ledit deuxième substrat (3), chacune desdites deuxièmes électrodes (5) ayant une extension longitudinale dans ladite direction z, et les électrodes de ladite pluralité de deuxièmes électrodes (5) étant espacées sensiblement dans la direction x qui est perpendiculaire à ladite direction z et, dans la direction x, sensiblement centrées autour d'un deuxième axe dirigé dans ladite direction z, ladite pluralité de deuxièmes électrodes continues comprenant une deuxième paire d'électrodes extérieures ; les électrodes de ladite pluralité desdites premières et desdites deuxièmes électrodes (4, 5) étant disposées entre lesdits premier et deuxième substrats (2, 3) ;
au moins une couche active (8) disposée entre ladite pluralité de premières électrodes (4) et ladite pluralité de deuxièmes électrodes (5) ;
un ensemble d'électrodes extérieures consistant en ladite première paire d'électrodes extérieures et ladite deuxième paire d'électrodes extérieures,
ladite feuille photovoltaïque (1) comprenant en outre au moins deux modules photovoltaïques, chaque module photovoltaïque comprenant :
- une paire de connecteurs comprenant un premier et un deuxième connecteur conducteur d'électrons, une première partie de borne dudit premier connecteur conducteur d'électrons étant disposée en contact physique avec une première électrode extérieure dans ledit ensemble d'électrodes extérieures, et une première partie de borne dudit deuxième connecteur conducteur d'électrons étant en contact physique avec une deuxième électrode extérieure dans ledit ensemble d'électrodes extérieures, lesdites première et deuxième électrodes extérieures étant disposées sur des côtés opposés d'un plan coïncidant avec lesdits premier et deuxième axes, **caractérisée par**
- un cadre continu (9a, 9b) d'un premier matériau adhésif non conducteur disposé entre ladite pluralité respective de premières et deuxièmes électrodes continues et disposé entre ledit premier et ledit deuxième substrat (2, 3), faisant adhérer les premier et deuxième substrats (2, 3) l'un à l'autre, lequel cadre s'étend à travers au moins une partie de chaque électrode de ladite pluralité de premières électrodes et à travers au moins une partie de chaque électrode dans ladite pluralité de deuxièmes électrodes et encadre une partie respective de ladite première pluralité de premières électrodes et une partie respective de ladite pluralité de deuxièmes électrodes.

2. Feuille photovoltaïque (1) selon la revendication 1, dans laquelle chacun desdits premiers et deuxièmes connecteurs conducteurs d'électrons comprend en outre une deuxième partie de borne et une partie intermédiaire disposée entre lesdites première et deuxième parties de borne, dans laquelle, pour chaque paire de connecteurs, ladite partie intermédiaire desdits premier et deuxième connecteurs conducteurs d'électrons est disposée entre un desdits premier et deuxième substrats souples et une partie dudit cadre continu de matériau adhésif, et ladite deuxième partie de borne desdits premier et deuxième connecteurs conducteurs d'électrons est de préférence disposée à l'extérieur dudit cadre continu dudit premier matériau adhésif (4, 5).

3. Feuille photovoltaïque (1) selon la revendication 2, dans laquelle ladite première partie de borne est allongée et s'étend dans ladite direction z, chacun desdits premiers et deuxièmes connecteurs conducteurs d'électrons comprend une partie sensiblement en forme de U ou de V, laquelle partie sensiblement en forme de U ou de V encercle partiellement une partie allongée disposée sur le côté de ladite pluralité de premières et deuxièmes électrodes continues, dans laquelle ladite partie sensiblement en forme de U ou de V comprend deux parties allongées, dans laquelle une desdites parties allongées coïncide avec ladite première partie de borne et l'autre s'étend de préférence dans une direction sensiblement parallèle à ladite première partie allongée.

4. Feuille photovoltaïque (1) selon l'une quelconque des revendications précédentes, dans laquelle des parties respectives (9b) de deux cadres adjacents parmi lesdits au moins deux cadres sont constituées d'une couche continue de matériau adhésif et/ou coïncident au moins partiellement.

5. Feuille photovoltaïque (1) selon l'une quelconque des revendications précédentes, dans laquelle ledit premier matériau adhésif non conducteur est un adhésif sensible à la pression (PSA), de préférence choisi dans un groupe constitué par les polymères d'acrylate, le caoutchouc naturel, les élastomères thermoplastiques de synthèse et le caoutchouc de silicone.

6. Feuille photovoltaïque (1) selon l'une quelconque des revendications précédentes, dans laquelle l'épaisseur de chacun desdits au moins deux cadres dans une direction perpendiculaire auxdits premier et deuxième substrats se situe dans une plage de 10 nm à 50 µm.

7. Feuille photovoltaïque (1) selon l'une quelconque des revendications précédentes, dans laquelle chacun desdits au moins deux cadres est formé d'une ou plusieurs lignes ayant chacune une direction d'extension respective, dans laquelle la largeur de chaque ligne se situe dans une plage de 10 µm à 100 mm dans une direction parallèle audit substrat et transversale à la direction d'extension de ladite ligne.

8. Feuille photovoltaïque (1) selon l'une quelconque des revendications précédentes, ladite feuille photovoltaïque (1) comprenant en outre une couche de transport d'électrons (7) disposée entre ladite au moins une couche active (8) et soit ladite pluralité de premières électrodes (4), soit ladite pluralité de deuxièmes électrodes (5), et dans laquelle chacun desdits au moins deux cadres (9a, 9b) dudit premier matériau adhésif non conducteur comprend au moins une partie disposée entre ladite couche de transport d'électrons (7) et ladite au moins une couche active (8).

9. Feuille photovoltaïque (1) selon l'une quelconque des revendications précédentes, ladite feuille photovoltaïque (1) comprenant en outre une couche de transport de trous (6) disposée entre ladite au moins une couche active (8) et soit ladite pluralité de premières électrodes (4), soit ladite pluralité de deuxièmes électrodes (5), et dans laquelle chacun desdits au moins deux cadres (9a, 9b) dudit premier matériau adhésif non conducteur comprend au moins une partie disposée entre ladite couche de transport de trous (6) et ladite au moins une couche active (8).

10. Feuille photovoltaïque (1) selon l'une quelconque des revendications précédentes, dans laquelle chacun desdits au moins deux cadres (9a, 9b) dudit premier matériau adhésif non conducteur encadre un module photovoltaïque respectif (12), et ladite feuille photovoltaïque (1) étant conçue pour être découpée le long d'au moins une ligne de coupe dans le plan x-z pour séparer au moins un desdits modules photovoltaïques (12) des autres modules photovoltaïques de ladite pluralité de modules photovoltaïques, dans laquelle ladite ligne de coupe coïncide de préférence avec au moins une partie dudit cadre dudit matériau adhésif.

11. Module photovoltaïque (12) comprenant une première partie de substrat d'un premier substrat souple (2) et une deuxième partie de substrat d'un deuxième substrat souple (3), ladite première et ladite deuxième partie de substrat étant au moins partiellement superposées, ledit module photovoltaïque comprenant en outre :
une pluralité de premières électrodes (4) disposées en contact physique avec ladite première partie de substrat, chacune desdites premières électrodes (4) ayant une extension longitudinale sensiblement dans la direction z, et les électrodes de ladite pluralité de premières électrodes (4) étant espacées sensiblement dans la direction x qui est perpendiculaire à ladite direction z, et sensiblement centrées autour d'un premier axe dirigé dans ladite direction z, ladite pluralité de premières électrodes continues comprenant une première paire d'électrodes extérieures,
une pluralité de deuxièmes électrodes (5) disposées en contact physique avec ladite deuxième partie de substrat, chacune desdites deuxièmes électrodes (5) ayant une extension longitudinale dans ladite direction z, et les électrodes de ladite pluralité de deuxièmes électrodes (5) étant espacées sensiblement dans la direction x qui est perpendiculaire à ladite direction z, et sensiblement centrées autour d'un deuxième axe dirigé dans ladite direction z, ladite pluralité de deuxièmes électrodes continues comprenant une deuxième paire d'électrodes extérieures, les électrodes de ladite pluralité desdites premières et desdites deuxièmes électrodes (4, 5) étant disposées entre lesdites première et deuxième parties de substrat,
un ensemble d'électrodes extérieures consistant en ladite première paire d'électrodes extérieures et ladite deuxième paire d'électrodes extérieures,
une paire de connecteurs comprenant un premier et un deuxième connecteur conducteur d'électrons, une première partie de borne dudit premier connecteur conducteur d'électrons étant disposée en contact direct avec une première électrode extérieure dans ledit ensemble d'électrodes extérieures, et une première partie de borne dudit deuxième connecteur conducteur d'électrons étant en contact direct avec une deuxième électrode extérieure dans ledit ensemble d'électrodes extérieures, lesdites première et deuxième électrodes extérieures étant disposées sur des côtés opposés d'un plan coïncidant avec lesdits premier et deuxième axes,
au moins une couche active (8) disposée entre ladite pluralité de premières électrodes (4) et ladite pluralité de deuxièmes électrodes (5) ;
**caractérisée par**
ledit module photovoltaïque (12) comprend en outre au moins un cadre continu d'un premier matériau adhésif non conducteur disposé entre ladite première et ladite deuxième partie de substrat, faisant adhérer les premier et deuxième substrats (2, 3) l'un à l'autre, lequel cadre s'étend à travers au moins une partie de chaque électrode de ladite pluralité de premières électrodes et à travers au moins une partie de chaque électrode dans ladite pluralité de deuxièmes électrodes, et dans lequel ledit au moins un cadre dudit premier matériau adhésif encadre une partie respective de ladite pluralité de premières électrodes (4) et encadre une partie respective de ladite pluralité de deuxièmes électrodes (5).

12. Procédé de production d'une feuille photovoltaïque (1), ledit procédé comprenant les étapes suivantes :
a) obtention d'un premier substrat souple (2) et d'un deuxième substrat souple (3) ;
b) application d'une pluralité de premières électrodes continues (4) sur ledit premier substrat souple (2) et d'une pluralité de deuxièmes électrodes continues (5) directement sur ledit deuxième substrat souple (3) ; lesdites premières et lesdites deuxièmes électrodes continues (4, 5) s'étendant dans la direction z et étant espacées dans la direction x qui est perpendiculaire à ladite direction z ;
c) obtention d'au moins deux paires de connecteurs, chaque paire de connecteurs comprenant un premier et un deuxième connecteur conducteur d'électrons, et mise de chaque premier connecteur conducteur d'électrons en contact physique avec une première électrode extérieure de ladite pluralité de premières et deuxièmes électrodes, et chaque deuxième connecteur conducteur d'électrons est en contact physique avec une deuxième électrode extérieure de ladite pluralité de premières et deuxièmes électrodes ;
d) application d'au moins une couche active (8) sur ladite pluralité de premières électrodes (4) et/ou ladite pluralité de deuxièmes électrodes (5) ;
e) application d'au moins deux cadres continus ou discontinus d'un premier matériau adhésif non conducteur sur ledit premier et/ou ledit deuxième substrat (2, 3), de telle sorte que chacun desdits au moins deux cadres dudit premier matériau adhésif encadre une partie respective de ladite première pluralité de premières électrodes (4) ;
f) stratification au moyen de chaleur et/ou de pression dudit premier et dudit deuxième substrat (2, 3) l'un avec l'autre de telle sorte que ledit premier matériau adhésif fasse adhérer les premier et deuxième substrats (2, 3) l'un à l'autre pour former ladite feuille photovoltaïque (1) ;
**caractérisé en ce que** les électrodes de ladite pluralité de premières et deuxièmes électrodes (4, 5) sont disposées entre lesdits premier et deuxième substrats (2, 3) ; de telle sorte que ladite au moins une couche active (8) est disposée entre et en contact électrique avec ladite pluralité de premières électrodes (4) et ladite pluralité de deuxièmes électrodes (5), et de telle sorte que chacun desdits au moins deux cadres dudit premier matériau adhésif est continu et s'étend à travers au moins une partie de chaque électrode de ladite pluralité de premières électrodes, à travers au moins une partie de chaque électrode dans ladite pluralité de deuxièmes électrodes, et à travers une paire respective desdites au moins deux paires de connecteurs, et dans lequel, après stratification, ledit au moins un cadre dudit premier matériau adhésif encadre une partie respective de ladite première pluralité de premières électrodes et une partie respective de ladite pluralité de deuxièmes électrodes (12).

13. Procédé selon la revendication 12, dans lequel l'étape e) se déroule avant l'étape d).

14. Procédé selon la revendication 12 ou 13, dans lequel l'étape e) comprend la formation d'une partie respective dudit matériau adhésif de deux cadres adjacents par une couche continue dudit premier matériau adhésif non conducteur.

15. Procédé selon l'une quelconque des revendications 12 à 14, comprenant en outre l'étape suivante :
g) après ladite stratification, découpe de ladite feuille photovoltaïque (1) le long d'au moins une ligne de coupe s'étendant dans le plan x-z pour séparer au moins un desdits modules photovoltaïques (12) de ladite pluralité de modules photovoltaïques ; dans lequel ladite ligne de coupe coïncide de préférence avec au moins une partie dudit cadre dudit premier matériau adhésif.

16. Procédé selon la revendication 14, ledit procédé comprenant en outre les étapes suivantes :
h) obtention d'un premier et d'un deuxième substrat barrière (104, 105) ;
i) application d'un deuxième matériau adhésif sur ledit premier et/ou ledit deuxième substrat barrière (104, 105) ;
j) positionnement d'au moins un desdits modules photovoltaïques (12) sur ledit premier ou ledit deuxième substrat barrière (104, 105) ;
k) stratification dudit premier et dudit deuxième substrat barrière (104, 105) l'un avec l'autre de telle sorte que ledit au moins un module photovoltaïque (12) soit disposé entre ledit premier et ledit deuxième substrat barrière (104, 105).

17. Procédé selon l'une quelconque des revendications 12 à 16, ledit procédé d'obtention d'au moins deux paires de connecteurs comprenant en outre les étapes d'obtention de chacun desdits premiers et deuxièmes connecteurs conducteurs d'électrons avec une partie sensiblement en forme de U ou de V, laquelle partie sensiblement en forme de U ou de V encercle partiellement une partie allongée disposée sur le côté de ladite pluralité de premières et deuxièmes électrodes continues, dans lequel ladite partie sensiblement en forme de U ou de V comprend deux parties allongées, dans lequel une desdites parties allongées coïncide avec ladite première partie de borne et l'autre s'étend de préférence dans une direction sensiblement parallèle à ladite première partie allongée.
